(19) Europäisches Patentamt
European Patent Office
Office européen des brevets

(11) **EP 4 575 352 A1**

(12) **EUROPÄISCHE PATENTANMELDUNG**

(43) Veröffentlichungstag:
25.06.2025 Patentblatt 2025/26

(21) Anmeldenummer: 24219235.9

(22) Anmeldetag: 11.12.2024

(51) Internationale Patentklassifikation (IPC):
**F25B 9/00** (2006.01)   **F25B 9/14** (2006.01)
**F17C 13/00** (2006.01)   **F17C 5/04** (2006.01)

(52) Gemeinsame Patentklassifikation (CPC):
**G01R 33/3804; F17C 5/04; F17C 13/006; F25B 9/002; F25B 9/14; F25B 9/145;** F25B 2400/17; G01R 33/3815

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **18.12.2023   DE 102023212894**

(71) Anmelder: **Bruker Switzerland AG**
**8117 Fällanden (CH)**

(72) Erfinder: **Wikus, Patrick**
**8309 Nürensdorf (CH)**

(74) Vertreter: **Kohler Schmid Möbus Patentanwälte Partnerschaftsgesellschaft mbB**
**Gropiusplatz 10**
**70563 Stuttgart (DE)**

(54) **VORRICHTUNG UND VERFAHREN ZUM TRANSFER VON FLÜSSIGEM HELIUM IN EINEN ANWENDUNGSKRYOSTATEN**

(57) Eine Vorrichtung (101) zum Transfer von flüssigem Helium (14) in einen Anwendungskryostaten (102), umfassend
- einen Vorratsdewar (1),
- eine Transferleitung (9) umfassend ein erstes Transferleitungs-Ende (9a) im Vorratsdewar (1) und ein zweites Transferleitungs-Ende (9b) zum Einstecken in einen Anwendungskryostaten (102),
- eine Einrichtung (31) zur Erzeugung einer Druckdifferenz zwischen Vorratsdewar (1) und Anwendungskryostat (102),
ist gekennzeichnet durch
- einen Kondensationswärmetauscher (17) zum Kondensieren von Heliumgas (12) zu flüssigem Helium (11), zum Einstecken in den Anwendungskryostaten (102),
- einen Kryokühler (29) zum Kühlen des Kondensationswärmetauschers (17), und
- eine Steuereinrichtung (8), mit einem Messeingang (18a) für einen Drucksensor (18) zur Messung des Gasdrucks im Anwendungskryostaten (102) und einen Steuerausgang (31a) für die Einrichtung (31) zur Erzeugung einer Druckdifferenz, wobei die Steuereinrichtung (8) dazu programmiert ist, die Einrichtung (31) zur Erzeugung einer Druckdifferenz so zu steuern, dass ein Volumen von pro Zeiteinheit durch die Transferleitung (9) transferiertem flüssigen Helium (14) näherungsweise gleich ist der Volumenänderung des Heliums, welches pro Zeiteinheit am Kondensationswärmetauscher (17) von Heliumgas (12) zu flüssigem Helium (11) kondensiert. Mit der Vorrichtung werden Heliumverluste beim Transfer von flüssigem Helium auf einfache Weise minimiert.

Fig. 1

**EP 4 575 352 A1**

**Beschreibung**

Die Erfindung betrifft eine Vorrichtung zum Transfer von flüssigem Helium in einen Anwendungskryostaten, umfassend

- einen Vorratsdewar für flüssiges Helium,
- eine Transferleitung für flüssiges Helium, zum Überführen von flüssigem Helium aus dem Vorratsdewar in den Anwendungskryostaten, umfassend ein erstes Transferleitungs-Ende, angeordnet im Vorratsdewar, und ein zweites Transferleitungs-Ende, zum Einstecken in den Anwendungskryostaten, und
- eine Einrichtung zur Erzeugung einer Druckdifferenz zwischen dem Vorratsdewar und dem Anwendungskryostaten.

Eine solche Vorrichtung ist bekannt geworden aus der Firmendruckschrift "NMR Magnet System UltraShield Magnets (English Version) User Manual", Version 006 (12.10.2004), chapter 12, der Bruker BioSpin AG, Fällanden, Schweiz.

Supraleitende Magnete, beispielsweise für die NMR-Spektroskopie (NMR=nuclear magnetic resonance) oder die Magnetresonanz-Bildgebung, auch als MRI bezeichnet (MRI=magnetic resonance imaging), benötigen eine Kühlung, um den supraleitenden Zustand der Magnete sicherzustellen. In vielen Fällen wird der supraleitende Magnet in einem Anwendungskryostaten angeordnet, in welchem flüssiges Helium bevorratet ist, typischerweise bei einer Temperatur von ca. 4,2 K, was dem Siedepunkt des flüssigen Heliums bei Atmosphärendruck entspricht. Auch aus anderen Anwendungsbereichen ist es bekannt, eine Kühlung mit flüssigem Helium vorzunehmen.

Da der Anwendungskryostat keine perfekte thermische Isolation bewirken kann, oder auch durch die jeweilige Anwendung Wärme in den Anwendungskryostaten eingebracht wird, verdampft das flüssige Helium während des Betriebs. Wenn der Füllstand an flüssigem Helium im Anwendungskryostaten für einen Weiterbetrieb zu weit abgesunken ist, wird flüssiges Helium in den Anwendungskryostaten nachgefüllt.

Es sei hier angemerkt, dass Helium ist eine knappe Ressource ist. Helium ist ein Nebenprodukt der Erdgasförderung. Die Verfügbarkeit von Helium am Weltmarkt wird immer geringer, und der Preis für Helium steigt, vgl. hierzu D. Kramer, "Helium is again short in supply", Physics Today, 4. April 2022, American Institute of Physics, https://doi.org/10.1063/PT.6.2.20220404a.

Daher werden Anstrengungen unternommen, den Verbrauch von Helium für den Betrieb von Anwendungskryostaten zu minimieren. Viele Verbraucher investieren in Anlagen zur Heliumrückgewinnung, mit denen abdampfendes Helium aufgefangen und rückverflüssigt werden kann.

Ein erheblicher Verlust von Helium tritt bei dem üblichen Vorgehen beim Nachfüllen von flüssigem Helium aus einem Vorratsdewar in den Anwendungskryostaten ein, wie es in der oben erwähnten Firmendruckschrift "NMR Magnet System UltraShield Magnets (English Version) User Manual" beschrieben ist. Dieses übliche Vorgehen lässt sich wie folgt zusammenfassen:

Schritt a) Der Vorratsdewar ("Transportdewar") wird in die Nähe des Anwendungskryostaten, in besagter Firmendruckschrift eines NMR-Magneten, bis auf wenige Meter Abstand verbracht.

Schritt b) Die warme Transferleitung wird in den Transportdewar gesteckt, sodass deren (erstes) Ende unterhalb der Flüssigkeitsoberfläche des enthaltenen flüssigen Heliums zu liegen kommt.

Schritt c) Durch den Wärmeeintrag der warmen Transferleitung verdampft Helium im Transportdewar. Dadurch steigt der Druck im Transportdewar, und flüssiges Helium wird in die Transferleitung gedrückt, die dadurch abgekühlt wird. Das Helium, das während des Abkühlvorgangs aus dem Ende der Transferleitung entweicht, wird üblicherweise nicht aufgefangen und geht in die Atmosphäre verloren. Für eine typische Transferleitung mit wenigen Metern Länge werden zum Abkühlen einige Liter flüssiges Helium benötigt.

Schritt d) Sobald das Helium, das aus dem (zweiten) Ende der Leitung entweicht, das dem Transportdewar abgewandt ist, ausreichend kalt ist (d.h. die Transferleitung ausreichend abgekühlt ist), wird die Transferleitung mit dem Anwendungskryostaten (z.B. einem NMR-Magneten) verbunden, d.h. das zweite Ende wird in den Anwendungskryostaten gesteckt.

Schritt e) Nachdem die Transferleitung mit dem Anwendungskryostaten verbunden wurde, fließt flüssiges Helium vom Transportdewar in den Anwendungskryostaten. Der Massenfluss wird getrieben durch den Druckunterschied, der zwischen Transportdewar und dem Anwendungskryostaten herrscht. Im Transportdewar hat sich durch das Einstecken der Transferleitung wie oben erwähnt ein Überdruck aufgebaut. In der Regel reicht der Druckaufbau im Transportdewar, der sich durch den Wärmeeintrag beim Einstecken den Transferleitung einstellt, jedoch nicht aus, um die gewünschte Menge flüssigen Heliums zu transferieren. Deshalb wird Heliumgas aus einer Druckgasflasche über einen Druckregler in den Transportdewar eingelassen, so dass der Druck im Transportdewar konstant hoch gehalten wird. Typischerweise liegt der Überdruck, der im Transportdewar eingestellt wird, bei etwa 50 - 100 mbar. Während des Transfers des flüssigen Heliums wird gasförmiges Helium entsprechend dem Volumen des einströmenden flüssigen Heliums an einem Ausgang aus dem Anwendungskryostaten herausgedrückt.

Zur Verdeutlichung: Zu Beginn des Transfers des flüssigen Heliums in den Anwendungskryostaten ist der Anwendungskryostat bzw. dessen Heliumtank typischerweise nicht leer, sondern enthält noch eine kleine Menge flüssigen Heliums, und ist in übrigen mit gasförmigem Helium bei einer Temperatur von 4,2 K bei einem Druck von ca. 1 bar befüllt. Wenn sich der Heliumtank im Laufe des Transfers langsam mit flüssigem Helium füllt, wird das kalte gasförmige Helium, das sich vor Beginn des Transfers im Heliumtank befand, sukzessive aus dem Heliumtank gedrückt und entweicht über den Ausgang des Anwendungskryostaten.

Gasförmiges Helium bei 4,2 K und Atmosphärendruck hat eine Dichte von 16,5 g/l. Flüssiges Helium bei 4,2 K und Atmosphärendruck hat eine Dichte von 125 g/l. Werden beispielsweise 100 Liter flüssiges Helium - also 12,5 kg Helium - transferiert, werden demnach 100 Liter gasförmiges Helium - also 1,65 kg - aus dem Anwendungskryostaten gedrückt. Das entspricht 13,2 Litern flüssigen Heliums oder 13,2% der transferierten Menge.

In den meisten Fällen entweicht diese Heliummenge über den Ausgang des Anwendungskryostaten einfach in die Atmosphäre, was nicht nachhaltig ist und auch den Betrieb des Anwendungskryostaten verteuert.

Alternativ ist es beispielsweise möglich, einen Gasballonspeicher zu installieren, der ausreichend groß dimensioniert ist, um das beim Heliumtransfer anfallende Helium (die "Transferverluste") am Ausgang aufzufangen und einem Hochdruckspeicher oder Verflüssiger zuzuführen. Im Leitungssystem, das zum Gasballon führt, und im Gasballon selbst erwärmt sich das gasförmige Helium auf Raumtemperatur, was zu einer großen Volumenzunahme des Gases führt. 100 Liter gasförmigen Heliums bei Atmosphärendruck und 4,2 K entsprechen etwa 10.000 Litern (also 10 m$^3$) bei Atmosphärendruck und Raumtemperatur.

Bei einem typischen Heliumtransfer in einen NMR-Magneten werden - abhängig vom Magnettyp - zwischen 100 und 400 Liter flüssiges Helium transferiert. Ein üblicher Transfer dauert etwa eine Stunde. In dieser Zeit fallen also zwischen 10 und 40 Kubikmeter gasförmiges Helium bei Raumtemperatur an, die in einem Gasballon gespeichert bzw. von einem Rückgewinnungssystem prozessiert (z.B. in Druckspeicher komprimiert) werden müssen, entsprechend 13 l/h bis 50 l/h flüssigen Heliums (oder zwischen etwa 1.6 und 6.6 kg Helium pro Stunde). Entsprechend große Gasballons bzw. leistungsfähige Rückgewinnungssysteme sind sehr platzaufwändig und auch sehr teuer.

In der nachveröffentlichten deutschen Offenlegungsschrift DE 10 2022 209 941 A1 wird vorgeschlagen, während des Transfers von flüssigem Helium vom Vorratsdewar in den Anwendungsdewar das am Anwendungskryostaten herausgedrückte gasförmige Helium über eine Rückführungsleitung dem Vorratsdewar zuzuleiten.

Zudem sei angemerkt, dass es auch möglich ist, Anwendungskryostate (zB enthaltend supraleitende Magnete für NMR-Anwendungen) im Dauerbetrieb aktiv mit einem Kryokühler zu kühlen, vgl. zum Beispiel die US 2002/0002830 A1. In diesem Fall ist es nicht nötig, flüssiges Helium nachzufüllen, und die Problematik von Heliumverlusten bei einem Nachfüllen von flüssigem Helium entfällt.

Die aktive Kühlung hat gegenüber einem passiven Betrieb mit einem Bad von flüssigem Helium jedoch diverse Nachteile, insbesondere die Einbringung von Vibrationen durch den Kryokühler in den Anwendungskryostaten, hohen Energieverbrauch (ca. 8 kW im Dauerbetrieb), verhältnismäßig hohe Wartungskosten, und verhältnismäßig lange Ausfallzeiten während der Wartungsaktivitäten. Im Falle von kryogenfreien aktiv gekühlten supraleitenden Magneten (d.h. supraleitenden Magneten, die über kein Puffervolumen von flüssigem Helium verfügen) kommt auch noch die sehr kurze Zeit von einem etwaigen Stromausfall bis zu einem Zusammenbruch der Supraleitung im supraleitenden Magneten ("Time-to-Quench") hinzu.

Die US 8,671,698 beschreibt einen vom Anwendungskryostaten separaten Heliumrückverflüssiger mit einem Pulsrohrkühler.

Aus der US 2007/0107445 A1 ist ein nachrüstbarer Rückverflüssiger für Helium bekannt geworden. Die Installation eines solchen Geräts ist recht aufwändig. Zudem können hier ebenfalls Vibrationen in den Anwendungskryostaten eingebracht werden, und es entstehen hohe Energie- und Wartungskosten.

Die US 8,375,742 B2 beschreibt einen Heliumrückverflüssiger, der mit einem eigenen Isolationsmantel ausgestattet ist. Aus einem Anwendungskryostaten abdampfendes Helium wird von dem Rückverflüssiger verflüssigt und über ein Transferrohr, das ebenfalls von dem Isolationsmantel umgeben ist, rückgeführt. In einer Variante ist zusätzlich ein Anschluss für eine externe Gasquelle vorgesehen.

Die US 2009/0301129 A1 beschreibt einen Heliumrückverflüssiger zum Nachrüsten an Magnetresonanz-Systemen, mit dem abdampfender Stickstoff und abdampfendes Helium rückverflüssigt werden sollen.

Aus der EP 0 245 057 B1 und der EP 0 396 624 B1 sind Kondensationswärmetauscher bekannt geworden, die über einen Kühlkreislauf mit einem Kaltkopf verbunden sind, und die in einem Kryostaten mit flüssigem Helium eingesteckt sind.

Die DE 10 2021 205 423 A1 beschreibt zudem eine Vorrichtung, in der mit einem einzigen Kaltkopf Helium gereinigt und verflüssigt wird.

Die DE 40 39 365 A1 beschreibt einen NMR-Magneten mit einem Kryostaten, in welchem in einer ersten, unteren Kammer unterkühltes flüssiges Helium und in einer oberen, zweiten Kammer flüssiges Helium unter Atmosphärendruck bei 4,2 K angeordnet ist, wobei zwischen den Kammern eine wärmeisolierende, aber druckdurchlässige Barriere angeordnet ist.

Auf der Webseite https://webbook.nist.gov/chemistry/fluid/ können thermophysikalische Eigenschaften verschiedener Fluidsysteme, beispielsweise für Helium, recherchiert werden. Diese Webseite wird betrieben vom National Institute of Standards and Technology (NIST), U.S. Department of Commerce.

Aus der DE 10 2020 204 186 A1 ist eine mobile Verflüssigungsanlage zum Verflüssigen von Helium bekannt geworden. Diese umfasst eine Verflüssigungseinrichtung für die Verflüssigung von Helium, einen Zwischenspeicher für verflüssigtes Helium, eine Reinigungseinrichtung für Helium und eine Zusatz-Sammeleinrichtung für gasförmiges Helium umfassend einen Behälter mit flexibler Wandung. Mit der Verflüssigungseinrichtung und der Reinigungseinrichtung kann am Ort eines Anwendungskryostaten gespeichertes, im Betrieb verdampftes Heliumgas gereinigt und verflüssigt und im Zwischenspeicher angesammelt werden. Beim Auffüllen des Anwendungskryostaten mit dem flüssigen Helium aus dem Zwischenspeicher kann verdampftes Heliumgas mit der Zusatz-Sammeleinrichtung aufgefangen werden.

Die DE 699 26 087 T2 beschreibt eine Vorrichtung zur Rekondensation von flüssigem Helium, wobei in einem Behälter flüssiges Helium bevorratet ist. In dem Behälter verdampftes gasförmiges Helium wird über eine Leitung zu einer außerhalb des Behälters angeordneten Kühleinrichtung geleitet und dort verflüssigt. Das verflüssigte Helium wird über eine weitere Leitung wieder in den Behälter geleitet.

### Aufgabe der Erfindung

Es ist Aufgabe der Erfindung, bei einem Transfer von flüssigem Helium von einem Vorratsdewar in einen Anwendungskryostaten auf einfache Weise Heliumverluste zu minimieren.

### Beschreibung der Erfindung

Diese Aufgabe wird erfindungsgemäß gelöst durch eine Vorrichtung der eingangs genannten Art, die dadurch gekennzeichnet ist,

dass die Vorrichtung weiterhin umfasst

- einen Kondensationswärmetauscher zum Kondensieren von Heliumgas zu flüssigem Helium, zum Einstecken in den Anwendungskryostaten,
- einen Kryokühler zum Kühlen des Kondensationswärmetauschers, und
- eine Steuereinrichtung, aufweisend zumindest einen Messeingang für einen Drucksensor zur Messung des Gasdrucks im Anwendungskryostaten und einen Steuerausgang für die Einrichtung zur Erzeugung einer Druckdifferenz, wobei die Steuereinrichtung dazu programmiert ist, die Einrichtung zur Erzeugung einer Druckdifferenz so zu steuern, dass ein Volumen von pro Zeiteinheit durch die Transferleitung transferiertem flüssigen Helium näherungsweise gleich ist der Volumenänderung des Heliums, welches pro Zeiteinheit am Kondensationswärmetauscher von Heliumgas zu flüssigem Helium kondensiert.

Mit der erfindungsgemäßen Vorrichtung wird ermöglicht, während eines Transfers von flüssigem Helium vom Vorratsdewar in den Anwendungkryostaten mit dem Kondensationswärmetauscher, welcher in den Anwendungskryostaten eingesteckt ist, eine in situ Verflüssigung von gasförmigem Helium zu flüssigem Helium im Anwendungskryostaten durchzuführen. Die Kühlleistung des Kondensationswärmetauschers (bzw. des Kryokühlers) einerseits und die Transferrate von flüssigem Helium in den Anwendungskryostaten andererseits können so aufeinander abgestimmt werden, dass die Volumenänderung (Volumenabnahme) des Heliums, welches pro Zeiteinheit im Anwendungskryostaten kondensiert, zumindest im Wesentlichen (und bevorzugt genau) demjenigen Volumen an flüssigem Helium entspricht, welches mittels der Einrichtung zur Erzeugung einer Druckdifferenz vom Vorratsdewar durch die Transferleitung in den Anwendungskryostaten transferiert wird ("Gleichgewichtslage"). Durch die Einstellung und Beibehaltung der Gleichgewichtslage während des Transfers von flüssigem Helium, die durch die Steuereinrichtung bewirkt wird, wird erreicht, dass während des Transfers von flüssigem Helium durch das einfließende flüssige Helium kein (oder nur sehr wenig) gasförmiges Helium aus dem Anwendungskryostaten herausgedrückt wird. Entsprechend entfällt die Notwendigkeit, herausgedrücktes gasförmiges Helium für eine Rückgewinnung aufzufangen und zu prozessieren. Insbesondere wird für den Transfer des flüssigen Heliums kein großer Gasballon zum Auffangen des herausgedrückten gasförmigen Heliums mehr benötigt.

Durch die mit der Einrichtung zur Erzeugung einer Druckdifferenz eingestellte Druckdifferenz zwischen dem Vorratsdewar und dem Anwendungskryostaten (wobei im Vorratsdewar ein höherer Druck als im Anwendungskryostaten vorgesehen ist, meist mit einer Druckdifferenz von 50-100 mbar) wird das flüssige Helium durch die Transferleitung in den Anwendungskryostaten gedrückt. Die Einrichtung zur Erzeugung (bzw. Einstellung) einer Druckdifferenz ist am Steuerausgang der Steuereinrichtung angeschlossen und wird von dieser gesteuert. Durch Erhöhung der Druckdifferenz kann die Transferrate an flüssigem Helium erhöht werden, und durch Absenken der Druckdifferenz kann die Transferrate an flüssigem Helium gesenkt werden. Man beachte, dass im Rahmen der Erfindung die Druckdifferenz als solches nicht bekannt zu sein braucht. Gleichwohl ist bevorzugt vorgesehen, dass die Steuereinrichtung zusätzlich mit einen weiteren Drucksensor auch den Druck im Vorratsdewar überwacht.

Die (zumindest näherungsweise) Einhaltung der Gleichgewichtslage wird bevorzugt dadurch sichergestellt, dass der Druck (Heliumgasdruck) im Anwendungskryostaten zumindest näherungsweise konstant gehalten wird, oder zumindest in einem vorgegebenen Druckintervall bleibt. Die Steuereinrichtung verwendet entsprechend typischerweise den Druck im Anwendungskryostaten als Eingangsgrö-ße (Regelgröße) oder zumindest als eine der Eingangsgrößen für die Ansteuerung der Einrichtung zur Erzeugung einer Druckdifferenz.

Die Einrichtung zur Erzeugung einer Druckdifferenz ist typischerweise dazu ausgebildet, den Druck (Gasdruck) im Vorratsdewar zu verändern, beispielsweise durch Veränderung des Stroms eines elektrischen Heizers im Vorratsdewar oder durch Veränderung der Stellung eines Stellventils (Einlassventils) in einer Heliumgasleitung von einem Heliumgasspeicher (insbesondere Helium-Druckgasspeicher) zum Vorratsdewar. Die Kühlleistung am Kondensationswärmetauscher bzw. die Kühlleistung von dessen Kryokühler bleibt typischerweise konstant. Es ist allerdings auch möglich, über eine Einrichtung zur Erzeugung einer Druckdifferenz alternativ oder zusätzlich den Druck im Anwendungskryostaten zu verändern, beispielsweise durch Veränderung des Stroms eines elektrischen Heizers im Anwendungskryostaten oder durch Veränderung der Kühlleistung am Kondensationswärmetauscher.

Der Kryokühler umfasst im Allgemeinen einen Kaltkopf und einen Kompressor. Der Kryokühler kann insbesondere einen Gifford-McMahon-Kühler umfassen, oder auch einen Pulsrohrkühler. Der Kaltkopf ist thermisch an den Kondensationswäretauscher gekoppelt, um diesen zu kühlen, bevorzugt über einen Kühlkreislauf. Der Kryokühler stellt die für die Kondensation des gasförmigen Heliums im Anwendungskryostaten benötigte Kühlleistung zur Verfügung.

Sollen im Rahmen der Erfindung beispielsweise 100 Liter flüssigen Heliums in den Anwendungskryostaten nachgefüllt werden, müssen während des Transfers des flüssigen Heliums entsprechend 100 Liter gasförmiges Helium (das bei einer Temperatur von 4,2 K ist) im Anwendungskryostaten verflüssigt werden, um das Ausströmen von Heliumgas aus dem Anwendungskryostaten zu vermeiden. Die Dichte von gasförmigem Helium bei 4,2 K und 1 bar beträgt 16,5 g/l; entsprechend müssen ca. 1,65 kg Helium verflüssigt werden. Helium hat eine latente Wärme von 20,6 kJ/kg, und entsprechend muss während des Transfers von flüssigem Helium eine Energie von etwa 34 kJ bei einer Temperatur von 4,2 K vom Kryokühler absorbiert werden. Wenn beispielsweise ein kommerziell verfügbarer Kryokühler mit einer Kühlleistung von 2 Watt dafür verwendet wird, dann kann diese Energie in ca. 4,7 Stunden absorbiert werden. Die im Rahmen der Erfindung zu verwendende Transferrate von flüssigem Helium beträgt dann ca. 21,3 l/h. In der Praxis wird die zu absorbierende Leistung noch geringfügig höher sein als besagte 34 kJ, da es beispielsweise durch die Heliumtransferleitung und durch den eingesteckten Kondensationswärmetauscher (zB angeordnet an einem Kühlstab) zu zusätzlichen Wärmeeinträgen ins System kommt. Dadurch verlängert sich die Transferzeit bzw. reduziert sich die Transferrate entsprechend geringfügig.

Die im Rahmen der Erfindung benötigte Zeit für den Transfer des flüssigen Heliums hängt, wie aus obigem Beispiel ersichtlich, insbesondere von der nachzufüllenden Menge an flüssigem Helium, von der Kühlleistung des Kryokühlers und von zusätzlichen Wärmeeinträgen durch unvollständige Isolation ab. Je nach zu erwartender Transferzeit kann der Transfer des flüssigen Heliums geplant werden, insbesondere auch als ein automatisierter Transfer "über Nacht", wenn ohnehin keine Anwendungen (zB NMR-Messungen) mit dem Anwendungskryostaten vorgenommen werden. Typische Transferzeiten im Rahmen der Erfindung liegen bei 1 h bis 16 h, und bevorzugt bei 2 h bis 12 h. Man beachte, dass die Transferzeit dabei verringert werden kann, wenn unterkühltes flüssiges Helium vom Vorratsdewar in den Anwendungskryostaten transferiert wird (siehe dazu auch weiter unten).

Der Vorratsdewar ist typischerweise transportabel ausgebildet ("Transportdewar"), bevorzugt mit Rollen, so dass er zwischen verschiedenen Labors hin- und hergefahren werden kann, und dann besonders leicht für die Nachfüllung von mehreren Anwendungskryostaten genutzt werden kann. Bevorzugt ist der Vorratsdewar mit dem Kryokühler zu einer integrierten transportablen Baugruppe (zB auf einer gemeinsamen Plattform mit Rollen angeordnet) zusammengefasst, insbesondere wenn der Vorratsdewar auch als Heliumverflüssiger dient.

Typischerweise gilt (während des Transfers von flüssigem Helium durch die Transferleitung) für das Volumen von pro Zeiteinheit durch die Transferleitung transferiertem flüssigen Helium $dV(LHe_{trans})/dt$ und für die Volumenänderung des Heliums, welches pro Zeiteinheit am Kondensationswärmetauscher von Heliumgas zu flüssigem Helium kondensiert $dV(He_{cond})/dt$ das Folgende:

$$|dV(He_{cond})/dt| \geq 0{,}75*|dV(LHe_{trans})/dt|,$$

$$\text{bevorzugt } |dV(He_{cond})/dt| \geq 0{,}9*|dV(LHe_{trans})/dt|.$$

Zudem gilt typischerweise auch:

$$|dV(He_{cond})/dt| \leq 1{,}25*|dV(LHe_{trans})/dt|,$$

$$\text{bevorzugt } |dV(He_{cond})/dt| \leq 1{,}1*|dV(LHe_{trans})/dt|.$$

<u>Bevorzugte Ausführunasformen der erfindungsgemäßen Vorrichtung</u>

Bei einer bevorzugten Ausführungsform der erfindungsgemäßen Vorrichtung ist die Steuereinrichtung dazu programmiert, während des Transfers von flüssigem Helium in den Anwendungskryostaten den Druck im Anwendungskryostaten näherungsweise konstant zu halten. Dadurch ist es auf besonders einfache Weise möglich, den Transferprozess in der Gleichgewichtslage zu halten, also so vorzunehmen, dass ein Volumen von pro Zeiteinheit durch die Transferleitung transferiertem flüssigen Helium näherungsweise gleich ist der Volumenänderung des Heliums, welches pro Zeiteinheit am Kondensationswärmetauscher von Heliumgas zu flüssigem Helium kondensiert. Typischerweise wird der gemessene Druck im Anwendungskryostaten von der Steuereinrichtung auf einen vorgegebenen, festen Zielwert eingeregelt. Man beachte, dass der Zielwert oberhalb des umgebenden Atmosphärendrucks liegen sollte (zB um 5 bis 50 mbar), um ein Einsaugen von Luft in den Anwendungskryostaten zu vermeiden. Alternativ ist es beispielsweise auch möglich, den gemessenen Druck auf einen Zielwert einzuregeln, der während des Transfers nachgeführt wird, z.B. mit einem festen Abstand zum umgebenden Atmosphärendruck.

Bevorzugt ist weiterhin eine Ausführungsform, bei der der Anwendungskryostat gegen einen Abfluss von gasförmigem Helium abgedichtet ist, unbeschadet etwaiger Sicherungseinrichtungen. Dies vereinfacht den Aufbau des gesamten Systems während des Transfers von flüssigem Helium, und es geht kein teures Helium beim Transferprozess verloren.

Bei einer vorteilhaften Ausführungsform ist vorgesehen, dass die Steuereinrichtung einen Drucksensor zur Messung des umgebenden Atmosphärendrucks aufweist, und dass die Steuereinrichtung dazu programmiert ist, den Druck im Anwendungskryostaten jederzeit oberhalb eines umgebenden Atmosphärendrucks zu halten, insbesondere durch eine entsprechende Ansteuerung der Einrichtung zur Erzeugung einer Druckdifferenz. Dadurch wird vermieden, dass Luft in den Anwendungskryostaten eingesaugt wird; ein Einsaugen von Luft kann zu Ausfrierung von Luftbestandteilen (zB Feuchtigkeit) im Anwendungskryostaten und damit zu einer Verstopfung des Gasflusses führen. Bevorzugt kann der Druck auch direkt im Anwendungskryostaten gesteuert werden, z.B. über einen am Kondensationswärmetauscher oder anderswo im Anwendungskryostaten angebrachten elektrischen Heizer. So kann in Fehlerfällen vermieden werden, dass der Druck im Anwendungskryostaten unzulässig tief sinkt (z.B. wenn die Transferleitung vereist und komplett blockiert ist).

In einer bevorzugten Ausführungsform umfasst die Einrichtung zur Erzeugung einer Druckdifferenz ein Stellventil in einer Heliumgasleitung, mit der Heliumgasleitung umfassend ein erstes Heliumgasleitungs-Ende angeschlossen an den Vorratsdewar, und ein zweites Heliumgasleitungs-Ende zum Anschließen an einen Heliumgasspeicher, insbesondere Helium-Druckgasspeicher. Mit dem Stellventil zum Heliumgasspeicher kann auf einfache und schnelle Weise der Druck im Transportdewar verändert werden. Das Stellventil ist von der Steuereinrichtung automatisiert betätigbar und verstellbar, zB mit einem Elektromotor. Man beachte, dass das aus dem Heliumgasspeicher in den Transportdewar einzulassende Helium vorgereinigt werden sollte, so dass Verunreinigungen (zB Wasserdampf oder Stickstoff) nicht in den Transportdewar und den Anwendungskryostaten gelangen und dort ausfrieren können. Bevorzugt ist der Transportdewar so eingerichtet, dass in ihm aus dem Heliumgasspeicher eingelassenes gasförmiges Helium verflüssigt werden kann, bevorzugt mit dem Kaltkopf des Kryokühlers, der auch zur Kühlung des Kondensationswärmetauschers dient. Bevorzugt wird ein gemeinsamer Kryokühler dazu verwendet, eine Kaltfalle zur Reinigung des Heliumgasses zu betreiben und das Heliumgas im Transportdewar zu verflüssigen; hierfür kann insbesondere eine Vorrichtung wie in der DE 10 2021 205 423 A1 beschrieben eingesetzt werden.

Bei einer vorteilhaften Ausführungsform umfasst die Einrichtung zur Erzeugung einer Druckdifferenz einen elektrischen Heizer im Vorratsdewar. Durch Heizen mit dem elektrischen Heizer im Vorratsdewar (bzw. in dessen Heliumbehälter) wird bevorratetes flüssiges Helium im Vorratsdewar verdampft, was den Druck im Vorratsdewar erhöht, wodurch der Transfer des flüssigen Heliums angetrieben werden kann. Dieses Vorgehen ist besonders einfach.

Besonders bevorzugt ist eines Ausführungsform, bei der die Vorrichtung weiterhin umfasst

- einen geschlossenen Kühlkreislauf eines Kühlmittels, umfassend eine Vorlaufleitung von einem Kaltkopf des Kryokühlers zum Kondensationswärmetauscher und eine Rücklaufleitung vom Kondensationswärmetauscher zum Kaltkopf des Kryokühlers,

wobei der Kryokühler dazu eingerichtet ist, das Kühlmittel mit dem Kaltkopf direkt oder indirekt zu kühlen, insbesondere wobei der Kaltkopf des Kryokühlers separat vom Anwendungskryostaten angeordnet ist. Durch die Einrichtung des Kühlkreislaufs kann der Ort der eigentlichen Kälteerzeugung (am Kaltkopf) vom Ort der Heliumkondensation (am Kondensationswärmetauscher) auf einfache Weise räumlich getrennt werden; der Kondensationswärmetauscher kann insbesondere am Ende eines steifen Kühlstabs eingerichtet werden, der auf einfache Weise in den Anwendungskryostaten eingeführt werden kann. Der Kaltkopf braucht nicht in den Anwendungskryostaten eingeschoben zu werden, was am Anwendungskryostaten sehr viel Platz einsparen kann, und in vielen Fällen auch nicht möglich wäre, da die Öffnungen in Anwendungskryostaten bevorzugt mit sehr kleinen Querschnitten (deutlich kleiner als handelsübliche Kaltköpfe) ausgebildet werden. Typischerweise ist der Kaltkopf auch separat vom Anwendungskryostaten angeordnet, was den Aufbau des Gesamtsystems vereinfacht. Zudem kann der Eintrag von Vibrationen in den Anwendungskryostaten minimiert werden. In den Kühlstab können ein Teil der Vorlaufleitung und der Rücklaufleitung, und gegebenenfalls auch ein Teil der Transferleitung integriert werden. Man beachte, dass der Kühlkreislauf meist auch eine Kompressor-Vorlaufleitung von einem separaten Kompressor zum Kaltkopf und eine und eine Kompressor-Rücklaufleitung vom Kaltkopf zum Kompressor umfasst.

Bei einer bevorzugten Weiterbildung dieser Ausführungsform verlaufen ausgehend vom Vorratsdewar die Vorlaufleitung, die Rücklaufleitung und die Transferleitung als Leitungsbündel in einem gemeinsamen Isolationsvakuum. Dieser Aufbau ermöglicht auf einfache Weise eine Isolation der Vorlaufleitung, Rücklaufleitung und Transferleitung. Das Leitungsbündel ist besonders einfach zu handhaben, insbesondere können das zweite Transferleitungs-Ende (Auslassende) der Transferleitung und der Kondensationswärmetauscher (am Ende der Vorlaufleitung/Anfang der Rücklaufleitung) besonders einfach gemeinsam in den Anwendungskryostaten eingesteckt werden. Meist ist das Leitungsbündel im hinteren Bereich, also nahe des zweiten Transferleitungs-Endes der Transferleitung und des Kondensationswärmetauschers, in einem steifen Rohr angeordnet ("Kühlstab"), was die Handhabung weiter vereinfacht.

Bevorzugt ist zudem eine Untervariante dieser Weiterbildung, bei der in dem gemeinsamen Isolationsvakuum die Vorlaufleitung und die Transferleitung thermisch miteinander gekoppelt sind, insbesondere durch eine Vielzahl von Kopplungsbrücken. Dadurch ist es möglich, mit dem Kühlkreislauf bzw. mit dem Kühlmittel in der Vorlaufleitung die Transferleitung vor Beginn des Transfers des flüssigen Heliums vorzukühlen, sodass die Heliumtransverleitung bereits kalt ist, wenn sie zu Beginn des Transfers von flüssigem Helium durchströmt wird. Dadurch wird kein flüssiges Helium für das Abkühlen der Transferleitung verbraucht (d.h. verdampft).

Bevorzugt ist weiterhin eine Ausführungsform, bei der die Vorrichtung weiterhin einen Heliumgasspeicher umfasst, der über eine Heliumgasleitung mit dem Vorratsdewar verbunden ist, insbesondere wobei der Heliumgasspeicher ein Helium-Druckgasspeicher ist. Dadurch ist es möglich, Heliumgas in den Vorratsdewar einzuleiten, insbesondere um den Druck im Vorratsdewar zu erhöhen (dann ist der Heliumspeicher meist ein Helium-Druckgasspeicher) und/oder um das eingeleitete gasförmige Helium im Vorratsdewar zu verflüssigen (wofür typischerweise der Kaltkopf des Kryokühlers in den Vorratsdewar bzw. dessen Vorrats-Kryostaten einragt, siehe auch unten).

Besonders bevorzugt ist eine Ausführungsform, bei der ein Kaltkopf des Kryokühlers und ein Heliumbehälter des Vorratsdewars in einem gemeinsamen Vorrats-Kryostaten angeordnet sind, wobei der Kaltkopf des Kryokühlers dazu eingerichtet ist, im Vorratsdewar Heliumgas in flüssiges Helium zu verflüssigen. Wenn im Vorratsdewar Helium verflüssigt werden kann, braucht kein flüssiges Helium zum Ort des Anwendungskryostaten über weite Strecken (zB mit einem Lastkraftwagen) verbracht werden, was technisch aufwändig wäre, so dass der Betrieb des Anwendungskryostaten deutlich verbilligt werden kann. Stattdessen kann leichter zu transportierendes gasförmiges Helium zum Anwendungskryostaten transportiert werden (etwa in Druckgasflaschen), und/oder im Normalbetrieb des Anwendungskryostaten abdampfendes Helium wird (typischerweise nach einer Zwischenspeicherung) im Anwendungskryostaten verflüssigt, was besonders nachhaltig ist.

Vorteilhaft ist zudem eine Weiterbildung dieser Ausführungsform, bei der der Heliumbehälter und der Kaltkopf dazu eingerichtet sind, im Heliumbehälter ein flüssiges unterkühltes Heliumvolumen bereitzustellen. Das unterkühlte Helium hat eine Temperatur unterhalb des Siedepunkts bei dem herrschenden Druck im Heliumbehälter. Meist liegt der Druck im Heliumbehälter bei ungefähr (aber geringfügig oberhalb von) 1 bar, entsprechend einem Siedepunkt von 4,2 K. Das unterkühlte flüssige Helium hat dann eine Temperatur von weniger als 4,2 K. Bevorzugt hat das unterkühlte flüssige Helium im Heliumbehälter eine Temperatur von 4,0 K oder weniger, besonders bevorzugt 3,8 K oder weniger. Allerdings ist die Bereitstellung von unterkühltem flüssigem Helium energetisch aufwändiger als die Bereitstellung von flüssigem Helium am Siedepunkt (4,2 K), wobei der energetische Aufwand mit sinkender Temperatur des unterkühlten flüssigen Heliums stark ansteigt. Daher hat das unterkühlte flüssige Helium im Heliumbehälter bevorzugt auch eine Temperatur von 3,7 K oder mehr. Wenn unterkühltes flüssiges Helium in den Anwendungskryostaten gefördert wird, steht zusätzliche Kühlleistung für die Kondensation von gasförmigem Helium in flüssiges Helium im Anwendungskryostaten zur Verfügung, entsprechend der Temperaturdifferenz zum Siedepunkt und der spezifischen Wärmekapazität des flüssigen Heliums. Dadurch kann der Transfer des flüssigen Heliums bei gegebener Kühlleistung des Kryokühlers schneller erfolgen als mit flüssigem Helium am Siedepunkt.

Besonders bevorzugt ist eine Untervariante zu dieser Weiterbildung, bei der im Heliumbehälter eine Thermalbarriere angeordnet ist, mit der das unterkühlte Heliumvolumen unterhalb der Thermalbarriere von einem flüssigen gesättigten Heliumvolumen oberhalb der Thermalbarriere getrennt wird. Mit diesem Aufbau kann eine Bereitstellung von unterkühltem flüssigen Helium besonders effizient und auch vergleichsweise einfach erfolgen. Eine Thermalbarriere, die im Rahmen dieser Erfindung genutzt werden kann, ist beispielsweise in der DE 40 39 365 A1 beschrieben. Die Thermalbarriere ist wärmeisolierend, aber druckdurchlässig. Der Kühlkopf des Kryokühlers kann dabei in einem separaten Vakuumraum angeordnet sein, der durch die Thermalbarriere ragt, so dass eine kälteste Stufe des Kaltkopfs Kühlleistung unterhalb der Thermalbarriere bereitstellen kann.

Bei einer weiteren Untervariante ist vorgesehen, dass eine Vorlaufleitung eines Kühlkreislaufs für Kühlmittel des Kryokühlers durch den Bereich des flüssigen unterkühlten Heliumvolumens verläuft. So steht für die Kühlung des Kondensationswärmetauschers ein großes Reservoir an "Kälteenergie" bei einer Temperatur kleiner als 4,2 K zu Verfügung. Durch die niedrigere Betriebstemperatur kann der Wärmeübergang am Kondensationswärmetauscher besonders effizient gestaltet werden.

Bei einer weiteren Untervariante mündet das erste Transferleitungs-Ende im Vorratsdewar im Bereich des flüssigen unterkühlten Heliumvolumens, insbesondere nahe eines Bodens des Heliumbehälters. Entsprechend kann durch die Transferleitung auf einfache Weise unterkühltes flüssiges Helium in den Anwendungskryostaten gefördert werden.

Vorteilhaft ist zudem eine Ausführungsform, bei der die Transferleitung im Bereich nahe dem ersten Transferleitungs-Ende ein Spülventil aufweist. Durch das Spülventil hindurch kann vor Beginn des Transfers an flüssigem Helium in der Transferleitung vorhandene Luft ausgeblasen werden. Dafür wird etwas gasförmiges Helium aus dem Anwendungskryostaten, der gegenüber der umgebenden Atmosphäre unter einem geringen Überdruck steht, durch die Transferleitung und durch das Spülventil geleitet. Dadurch kann ein Eintrag von Luft in den Anwendungskryostaten minimiert werden. Das Spülventil führt im einfachsten Fall in die umgebende Atmosphäre, oder alternativ zu einem Heliumrückgewinnungssystem (welches mit einer Reinigungsfunktion zur Abscheidung von Luftbestandteilen ausgestattet ist).

Erfindungsgemäße Anwendungssysteme

In den Rahmen der vorliegenden Erfindung fällt auch ein Anwendungssystem, umfassend eine erfindungsgemäße, oben beschriebene Vorrichtung sowie einen Anwendungskryostaten,

wobei die Transferleitung und der Kondensationswärmetauscher in den Anwendungskryostaten eingesteckt sind, insbesondere in ein gemeinsames Zugangsrohr des Anwendungskryostaten. In dem erfindungsgemäßen Anwendungssystem kann auf einfache Weise ein Transfer von flüssigem Helium aus dem Vorratsdewar in den Anwendungskryostaten erfolgen, wobei Heliumverluste minimiert werden können. Wenn die Kondensationswärmetauscher (typischerweise an einem Kühlstab angeordnet) und die Transferleitung für das flüssige Helium dasselbe Zugangsrohr (insbesondere Aufhängerohr eines NMR-Magneten) nutzen, kann auf einfache Weise ein ausreichend großer Abströmquerschnitt für den Fall eines Quenchs (plötzlicher Verlust der Supraleitung des NMR-Magneten) zur Verfügung gestellt werden, nämlich am einem zweiten, nicht blockierten Zugangsrohr (insbesondere Aufhängerohr). Zudem ist eine thermische Kopplung der Transferleitung mit einer Vorlaufleitung eines Kühlmittels des Kondensationswärmetauschers leichter möglich.

Besonders bevorzugt ist eine Ausführungsform des erfindungsgemäßen Anwendungssystems, bei der der Anwendungskryostat eine supraleitende Magnetspule enthält und ein NMR-Probenkopf in eine Magnetbohrung der Magnetspule einragt. Der Anwendungskryostat kann dann für NMR-Messungen verwendet werden, und die Kosten für die NMR-Messungen an Proben können aufgrund von vergleichsweise geringen Betriebskosten im Rahmen der Erfindung reduziert werden. Typischerweise ragt der NMR-Probenkopf in eine Raumtemperaturbohrung des Anwendungskryostaten, die mit der Magnetbohrung koaxial ist.

Erfindungsgemäße Verfahren zum Transfer von flüssigem Helium

Ebenso fällt in den Rahmen der vorliegenden Erfindung ein Verfahren zum Transfer von flüssigem Helium in einen Anwendungskryostaten,

insbesondere unter Verwendung einer erfindungsgemäßen, oben beschriebenen Vorrichtung oder eines erfindungsgemäßen, oben beschriebenen Anwendungssystems,
wobei eine Transferleitung für flüssiges Helium mit einem ersten Transferleitungs-Ende an einen Vorratsdewar enthaltend flüssiges Helium angeschlossen ist, und mit einem zweiten Transferleitungs-Ende in den Anwendungskryostaten eingesteckt ist,

wobei von dem Vorratsdewar über die Transferleitung flüssiges Helium in den Anwendungskryostaten transferiert wird,

wobei mit einer Einrichtung zur Veränderung einer Druckdifferenz zwischen dem Vorratsdewar und dem Anwendungskryostaten ein Fluss an flüssigem Helium durch die Transferleitung eingestellt wird,

dadurch gekennzeichnet,

dass ein Kondensationswärmetauscher, der mit einem Kryokühler gekühlt wird, in den Anwendungskryostaten eingesteckt ist und im Anwendungskryostaten gasförmiges Helium zu flüssigem Helium verflüssigt,

und dass eine Steuereinrichtung einen Druck im Anwendungskryostaten misst und die Einrichtung zur Veränderung einer Druckdifferenz so ansteuert, dass ein Volumen von pro Zeiteinheit durch die Transferleitung transferiertem flüssigen Helium näherungsweise gleich ist der Volumenänderung des Heliums, welches pro Zeiteinheit am Kondensationswärmetauscher von Heliumgas zu flüssigem Helium kondensiert. Im Rahmen des erfindungsgemäßen Verfahrens wird erreicht, dass beim Nachfüllen von flüssigem Helium aus dem Vorratsdewar kein oder nur wenig Heliumgas durch das einströmende flüssige Helium aus dem Anwendungskryostaten gedrückt wird. Dies wird dadurch erreicht, dass während des Einfüllens des flüssigen Heliums in den Anwendungskryostaten vorhandenes Heliumgas im Anwendungskryostaten mit dem Kondensationswärmetauscher verflüssigt wird, so dass die zugehörigen Volumina/Volumenänderungen sich näherungsweise entsprechen ("Gleichgewichtslage"). Entsprechend geht kein oder nur wenig Heliumgas beim Transfer des flüssigen Heliums verloren. Ein etwaiges Heliumrückgewinnungssystem für die Speicherung und Rückverflüssigung des herausgedrückten Heliumgases ist nicht notwendig oder kann vergleichsweise klein und kostengünstig ausgestaltet werden.

Besonders bevorzugt ist eine Variante des erfindungsgemäßen Verfahrens, bei der die Steuereinrichtung während des Transfers von flüssigem Helium in den Anwendungskryostaten den Druck im Anwendungskryostaten näherungsweise konstant hält. Durch dieses Vorgehen kann auf einfache Weise erreicht werden, dass das Volumen von pro Zeiteinheit durch die Transferleitung transferiertem flüssigen Helium näherungsweise gleich ist der Volumenänderung des Heliums, welches pro Zeiteinheit am Kondensationswärmetauscher von Heliumgas zu flüssigem Helium kondensiert ("Gleichgewichtslage").

Bei einer bevorzugten Variante findet während des Transfers von flüssigem Helium kein Abfluss von gasförmigem Helium aus dem Anwendungskryostaten statt. Dadurch können Heliumverluste beim Transfer des flüssigen Heliums vollständig beseitigt werden, ohne dass ein Heliumrückgewinnungssystem benötigt würde.

Vorteilhaft ist auch eine Variante, die vorsieht, dass die Steuereinrichtung einen umgebenden Atmosphärendruck misst, und dass die Steuereinrichtung den Druck im Anwendungskryostaten jederzeit oberhalb des umgebenden Atmosphärendrucks hält, insbesondere durch eine entsprechende Ansteuerung der Einrichtung zur Erzeugung einer Druckdifferenz. Dadurch wird ein Einsaugen von Luft aus der Umgebung in den Anwendungskryostaten verhindert. Falls ein zu starkes Absinken des Drucks im Anwendungskryostaten droht, wird in der Regel der Transfer von flüssigem Helium in den Anwendungskryostaten gesteigert (indem der Druck im Vorratsdewar erhöht wird); notfalls (zB bei Verstopfung der Transferleitung) kann, soweit vorhanden, ein elektrischer Heizer im Anwendungskryostaten eingeschaltet und/oder aufgedreht werden.

In einer bevorzugten Variante ist vorgesehen, dass die Steuereinrichtung als Einrichtung zur Veränderung einer Druckdifferenz ein Stellventil in einer Heliumgasleitung ansteuert, die von einem Heliumgasspeicher, insbesondere Helium-Druckgasspeicher, zum Vorratsdewar führt. Dadurch kann direkt und schnell der Druck im Vorratsdewar erhöht werden, um den Transfer von flüssigem Helium zu beginnen oder zu steigern.

Vorteilhaft ist auch eine Variante, bei der die Steuereinrichtung als Einrichtung zur Veränderung einer Druckdifferenz einen elektrischen Heizer im Vorratsdewar ansteuert. Ein elektrischer Heizer ist einfach und kostengünstig zu installieren. Durch den Heizer kann Helium im Vorratsdewar verdampft werden, was den Gasdruck im Vorratsdewar steigert. Ein Helium-Druckgasspeicher wird nicht benötigt (kann aber gleichwohl vorgesehen sein).

Bevorzugt ist auch eine Variante, bei der ein Kühlmittel in einem geschlossenen Kühlkreislauf durch eine Vorlaufleitung von einem Kaltkopf des Kryokühlers zum Kondensationswärmetauscher und durch eine Rücklaufleitung zurück zum Kühlkopf des Kryokühlers geführt wird, wobei der Kaltkopf des Kryokühlers das Kühlmittel direkt oder indirekt kühlt, insbesondere wobei der Kaltkopf separat vom Anwendungskryostaten angeordnet ist. Mit dem Kühlkreislauf kann der Kaltkopf vom Kondensationswärmetauscher räumlich getrennt werden, was Bauraum am Anwendungskryostaten (insbesondere im Bereich der Zugangsrohre) spart. Zudem kann der Kaltkopf leicht für weitere Zwecke eingesetzt werden, insbesondere für eine Verflüssigung von Helium im Vorratsdewar.

Besonders bevorzugt ist eine Variante, bei der die Transferleitung zwischen dem Vorratsdewar und dem Anwendungskryostaten mit der Vorlaufleitung thermisch koppelt. Dadurch kann die Transferleitung für das flüssige Helium über den Kühlkreislauf gekühlt werden.

Eine Weiterentwicklung dieser Variante sieht vor, dass vor Beginn eines Transfers von flüssigem Helium durch die Transferleitung die Transferleitung zunächst mit dem Kühlmittel in der Vorlaufleitung vorgekühlt wird. Wenn dann für einen Transfer erstmals flüssiges Helium durch die Transferleitung geleitet wird, ist die Transferleitung schon kalt, und kein oder nur wenig flüssiges Helium verdampft auf dem Weg zum Anwendungskryostaten. Dadurch kann flüssiges Helium eingespart werden.

Bevorzugt ist auch eine Variante, die vorsieht,

dass ein Kaltkopf des Kryokühlers und ein Heliumbehälter des Vorratsdewars in einem gemeinsamen Vorrats-Kryostaten angeordnet sind,
und dass vor Beginn des Transfers von flüssigem Helium gasförmiges Helium aus einem Heliumgasspeicher, insbesondere Helium-Druckgasspeicher, dem Vorratsdewar zugeführt wird und mit dem Kaltkopf im Vorratsdewar gasförmiges Helium in flüssiges Helium kondensiert wird. In dieser Variante kann flüssiges Helium vor Ort im Vorratsdewar erzeugt werden, und ein aufwändiger und schwieriger Transport von flüssigem Helium zum Anwendungs-Ort kann vermieden werden. Gegebenenfalls kann Helium in einem praktisch geschlossenen Kreislauf am Anwendungsort prozessiert werden, was nachhaltig und kostengünstig ist.

Besonders bevorzugt ist eine Variante, die vorsieht, dass in einem Heliumbehälter des Vorratsdewars ein flüssiges unterkühltes Heliumvolumen bereitgestellt wird, und dass das durch die Transferleitung transferierte flüssige Helium aus dem flüssigen unterkühlten Heliumvolumen entnommen wird. Das unterkühlte Heliumvolumen stellt eine zusätzliche Kühlleistung im Anwendungskryostaten bereit, die die Verflüssigung von Heliumgas im Anwendungskryostaten unterstützt, und der Transfer von flüssigem Helium kann besonders schnell erfolgen.

Vorteilhaft ist auch eine Weiterentwicklung der vorgenannten Variante, die vorsieht, dass der Kondensationswärmetauscher mit einem Kühlmittel, das in einem geschlossenen Kühlkreislauf zirkuliert, gekühlt wird, und dass das Kühlmittel in einer Vorlaufleitung durch den Bereich des flüssigen unterkühlten Heliumvolumens geführt wird. Dadurch kann ein besonders großes Reservoir an Kälteenergie bei einer Temperatur < 4,2 K für die Verflüssigung im Anwendungskryostaten genutzt werden. Der Kondensationswärmetauscher ist hoch effizient und leistungsstark.

Vorteilhaft ist auch eine Variante, bei der vor Beginn eines Transfers von flüssigem Helium zunächst die Transferleitung mit gasförmigen Helium aus dem Anwendungskrystaten über ein Spülventil, welches nahe dem ersten Transferleitungs-Ende in der Transferleitung angeordnet ist, gespült wird. Dadurch wird ein Eintrag von Verunreinigungen (Luftbestandteilen) in den Anwendungskryostaten minimiert. Die Verzweigung zum Spülventil liegt typischerweise im Bereich des Vorratsdewars. Typischerweise können mehr als 3/4 der Länge der Transferleitung über das Spülventil gespült werden.

Bevorzugt ist auch eine Variante, bei der der Anwendungskryostat im Wechsel in einem Normalbetrieb für eine Anwendung eingesetzt wird und in einem Nachfüllbetrieb mit flüssigem Helium befüllt wird,
wobei während des Normalbetriebs der Kondensationswärmetauscher und das zweite Transferleitungs-Ende nicht in den Anwendungskryostaten eingesteckt sind, und während des Nachfüllbetriebs der Kondensationswärmetauscher und das zweite Transferleitungs-Ende in den Anwendungskryostaten eingesteckt sind. Der Kondensationswärmetauscher und die Transferleitung werden nur eingesteckt, wenn sie gebraucht werden. Wärmeeinträge im Normalbetrieb in den Anwendungskryostaten können so minimiert werden.

Bevorzugt ist zudem eine Weiterentwicklung der oben genannten Variante, die vorsieht, dass im Anwendungskryostaten eine supraleitende Magnetspule angeordnet ist, und während des Normalbetriebs als Anwendung mit einem NMR-Probenkopf NMR-Messungen an Proben durchgeführt werden, die in einer Magnetbohrung der supraleitenden Magnetspule angeordnet sind. Im Rahmen der Erfindung sind nachhaltige und kostengünstige NMR-Messungen an den Proben möglich.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Fig. 1    zeigt eine schematische Ansicht einer ersten Ausführungsform eines erfindungsgemäßen Anwendungssystems, umfassend eine erfindungsgemäße Vorrichtung zum Transfer von flüssigem Helium sowie einen Anwendungskryostaten, wobei ein Kryokühler einen separaten Kryokühler-Kryostaten aufweist;

Fig. 2    zeigt ein Leitungsbündel von Transferleitung, Vorlaufleitung und Rücklaufleitung für die Erfindung;

Fig. 3    zeigt eine schematische Ansicht einer zweiten Ausführungsform eines erfindungsgemäßen Anwendungssystems, umfassend eine erfindungsgemäße Vorrichtung zum Transfer von flüssigem Helium sowie einen Anwendungskryostaten, wobei ein Kaltkopf des Kryokühlers und ein Heliumbehälter des Vorratsdewars in einem gemeinsamen Vorrats-Kryostaten angeordnet sind;

Fig. 4    zeigt eine Bauform für den Vorratsdewar für eine erfindungsgemäße Vorrichtung für den Transfer von flüssigem Helium, mit Thermalbarriere im Heliumbehälter des Vorratsdewars.

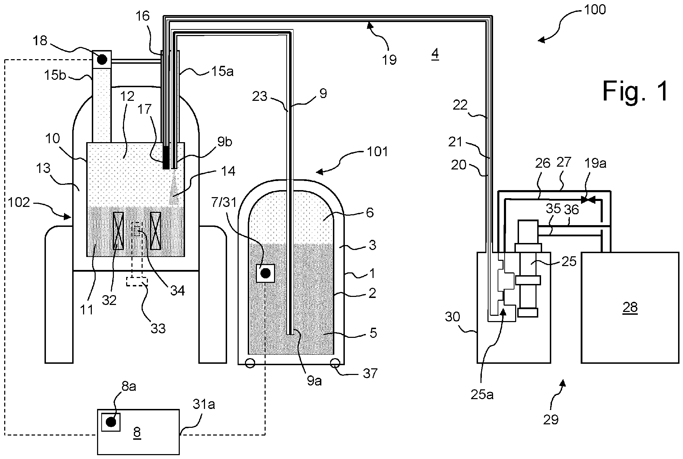

Die **Figur 1** zeigt schematisch eine erste Ausführungsform eines erfindungsgemäßen Anwendungssystems 100, umfassend eine Vorrichtung 101 zum Transfer von flüssigem Helium und einen Anwendungskryostaten 102, während eines Transfers von flüssigem Helium.

Die Vorrichtung 101 umfasst einen Vorratsdewar 1 mit einem Heliumbehälter 2, der durch ein Isolationsvakuum 3 thermisch von der Umgebung 4 entkoppelt ist. In der Umgebung 4 herrscht hier Raumtemperatur (20°C) und ein Atmosphärendruck $p_{atm}$ von 1,00 bar. Im Isolationsvakuum 3 können ein oder mehrere Strahlungsschilde oder mehrlagige Superisolation vorgesehen sein (nicht näher dargestellt).

Im Heliumbehälter 2 ist in einem unteren Bereich flüssiges Helium 5 bevorratet, und in einem oberen Bereich steht gasförmiges Helium 6 über dem flüssigen Helium 5. In der gezeigten Ausführungsform haben das flüssige Helium 5 und das gasförmige Helium 6 im Vorratsdewar 1 eine Temperatur von ca. 4,2 K, und im Vorratsdewar 1 herrscht hier ein Druck $p_{vorrat}$ von ca. 1,08 bar. In der gezeigten Ausführungsform ist zudem ein elektrischer Heizer 7 im Vorratsdewar 1 angeordnet, der mit einer elektronischen Steuereinrichtung 8 angesteuert werden kann.

In den Vorratsdewar 1 ragt eine Transferleitung 9 für flüssiges Helium hinein. Ein erstes Transferleitungsende 9a mündet im flüssigen Helium 5, nahe dem Boden des Heliumbehälters 2. Die Transferleitung 9 ist mit einer Vakuumisolierung 23 versehen. Der Vorratsdewar 1 ist transportabel ausgebildet, hier mit Rollen 37 ("Transportdewar").

Ein zweites Transferleitungsende 9b der Transferleitung 9 ist durch ein Zugangsrohr 15a in den Anwendungskryostaten 102 eingesteckt, und mündet in einem Heliumtank 10 des Anwendungskryostaten 102. Der Heliumtank 10 ist durch ein Isolationsvakuum 13 von der Umgebung 4 thermisch isoliert. Im Isolationsvakuum 13 können ein oder mehrere Strahlungsschilde vorgesehen sein (nicht näher dargestellt).

Im Heliumtank 10 des Anwendungskryostaten 102 befindet sich in einem unteren Bereich flüssiges Helium 11, und in einem oberen Bereich gasförmiges Helium 12. In der gezeigten Ausführungsform haben das flüssige Helium 11 und das gasförmige Helium 12 im Heliumtank 10 jeweils eine Temperatur von ca. 4,2 K, und im Heliumtank herrscht ein Druck $p_{anwend}$ von ca. 1,03 bar.

Zu den Drücken gilt (für den Transfer des flüssigen Heliums durch die Transferleitung 9) allgemein $p_{atm} < p_{anwend} < p_{vorrat}$.

Da der im Vorratsdewar 1 herrschende Druck $p_{vorrat}$ etwas größer ist als der im Anwendungskryostaten 102 herrschende Druck $p_{anwend}$, wird flüssiges Helium 5 aus dem Vorratsdewar 1 durch die Transferleitung 9 in den Anwendungskryostaten 102 gedrückt, vgl. das am zweiten Transferleitungsende 9b ausströmende flüssige Helium 14. Es wird also angetrieben durch eine Druckdifferenz zwischen dem Vorratsdewar 1 und dem Anwendungskryostaten 102 flüssiges Helium vom Vorratsdewar 1 in den Anwendungskryostsaten 102 transferiert.

Durch das Zugangsrohr 15a ragt hier nicht nur die Transferleitung 9, sondern auch ein Kühlstab 16 in den Anwendungskryostaten 102 ein; das Zugangsrohr 15a wird daher auch als gemeinsames Zugangsrohr 15a bezeichnet. An einem unteren Ende des Kühlstabs 16 ist ein Kondensationswärmetauscher 17 ausgebildet. Mit dem Kondensationswärmetauscher 17 wird während des Transfers von flüssigem Helium kontinuierlich gasförmiges Helium 12 im Heliumtank 10 verflüssigt.

Der Kondensationswärmetauscher 17 wird mit einem Kühlmittel gekühlt, welches in einem Kühlkreislauf 19 umläuft. Der Kühlkreislauf 19 verläuft mit einer Vorlaufleitung 20 von einem Kaltkopf-Wärmetauscher 25a an einem Kaltkopf 25 zum Kondensationswärmetauscher 17 und mit einer Rücklaufleitung 21 vom Kondensationswärmetauscher 17 zurück zum Kaltkopf-Wärmetauscher 25a am Kaltkopf 25. Dem Kondensationswärmetauscher 17 nahe Endbereiche der Vorlaufleitung 20 und Rücklaufleitung 21 verlaufen im Kühlstab 16. Die Vorlaufleitung 20 und die Rücklaufleitung 21 sind von einer Vakuumisolierung 22 umgeben. Der Kühlmittelkreislauf 19 wird dabei von einem Kompressor 28 angetrieben, wobei eine Kompressor-Vorlaufleitung 26 vom Kompressor zum Kaltkopf-Wärmetauscher 25a bzw. zur Vorlaufleitung 20 führt, und eine Kompressor-Rücklaufleitung 27 von der Rücklaufleitung 21 bzw. vom Kaltkopf-Wärmetauscher 25a zum Kompressor 28. Das Kühlmittel im Kühlkreislauf 19 kann insbesondere Helium sein. Der Kaltkopf 25 und der Kompressor 28 bilden den Kryokühler 29 der Vorrichtung 101.

Der Kompressor 28 betreibt hier den Kaltkopf 25, wobei eigene Kaltkopfleitungen 35, 36 zwischen Kompressor 28 und Kaltkopf 25 eingerichtet sind, und besorgt weiterhin die Kühlmittelzirkulation im Kühlkreislauf 19 des Kondensationswärmetauschers 17. Dies ist besonders kostengünstig. Dabei kann der Kühlkreislauf 19 über das Kühlkreislaufventil 19a, hier angeordnet in der Kompressor-Vorlaufleitung 26, separat aktiviert und deaktiviert werden.

Der Kaltkopf 25 und der Kaltkopf-Wärmetauscher 25a sind hier in einem Kryokühler-Kryostaten 30 angeordnet, der vom Anwendungskryostaten 102 und vom Vorratsdewar 1 separat ist. Der Kryokühler 29 kann insbesondere als ein Gifford-McMahon-Kühler oder Pulsrohrkühler aufgebaut sein. Die Kühlung des Kühlstabs 16 bzw. des Kondensationswärmetauschers 17 ist mit einem Kryokühler 29 bzw. einer Kältemaschine außerhalb des Anwendungskryostaten 102 eingerichtet.

Die Steuereinrichtung 8 überwacht mit einem Drucksensor 18, der hier an einem zweiten Zugangsrohr 15b des Anwendungskryostaten 102 angeordnet ist, den Druck $p_{anwend}$ im Anwendungskryostaten 102. Im Übrigen ist das zweite Zugangsrohr 15b frei, und kann insbesondere gut als Notfall-Ablass für Heliumgas dienen (etwa im Quenchfall). Der Drucksensor 18 ist an einem Messeingang 18a mit der Steuereinrichtung 8 verbunden. Weiterhin überwacht in der gezeigten Ausführungsform die Steuereinrichtung 8 mit einem in die Steuereinrichtung 8 integrierten Drucksensor 8a den Druck $p_{atm}$ in der Umgebung 4.

Die Steuereinrichtung 8 kontrolliert in der gezeigten Ausführungsform bei der Durchführung des Transfers von flüssigem Helium die Heizleistung des elektrischen Heizers 7 im Vorratsdewar 1. Über die Heizleistung am Heizer 7 kann der Druck im Vorratsdewar 1, und damit auch die Druckdifferenz zwischen Vorratsdewar 1 und Anwendungskryostat 102 verändert werden. Der Heizer 7 stellt hier somit eine Einrichtung 31 zur Erzeugung einer Druckdifferenz zwischen dem Vorratsdewar 1 und dem Anwendungskryostaten 102 dar. Der Heizer 7 ist an einen Steuerausgang 31a der Steuereinrichtung 8 angeschlossen.

Die Heizleistung wird von der Steuereinrichtung 8 so eingestellt und nachgeführt, dass im Anwendungskryostaten 102 der dortige Druck $p_{anwend}$ auf einen vorgegebenen Sollwert $p_{anwend}^{soll}$ eingeregelt wird. Der vorgegebene Sollwert $p_{anwend}^{soll}$ beträgt hier 1,03 bar und ist so gewählt, dass er geringfügig (hier um 0,03 bar) über dem Druck $p_{atm}$ der Umgebung 4 liegt. Im einfachsten Fall ist der vorgegebenen Sollwert $p_{anwend}^{soll}$ während des gesamten Dauer des Transfers an flüssigem Helium konstant. Sollte sich das Wetter, und damit der Luftdruck in der Umgebung 4 bzw. der mit dem Sensor 8a überwachte Druck $p_{atm}$, während des Transfers stark ändern, kann der vorgegebene Sollwert $p_{anwend}^{soll}$ nötigenfalls auch geändert werden, um mit dem Druck $p_{anwend}$ im Anwendungskryostaten 102 in einem gewünschten Abstand (Mindestabstand und/oder Höchstabstand) vom Druck $p_{atm}$ der Umgebung zu bleiben, insbesondere um ein Einsaugen von Umgebungsluft in den Anwendungskryostaten 102 zu vermeiden und/oder um ein Auslösen von Überdrucksicherungen (Überdruckventile, Berstscheiben, nicht näher dargestellt) am Anwendungskryostaten 102 zu verhindern.

Wenn während der Einförderung von flüssigem Helium in den Anwendungskryostaten 102 durch die Transferleitung 9 der Druck $p_{anwend}$ im Wesentlichen bei $p_{an-wend}^{soll}$ bleibt, dann entspricht im Wesentlichen das pro Zeiteinheit eingeförderte Volumen an flüssigem Helium $dV(LHe_{trans})/dt$ der Volumenänderung des Heliums $dV(He_{cond})/dt$, welches pro Zeiteinheit am Kondensationswärmetauscher 17 kondensiert ("Gleichgewichtslage"). In diesem Fall tritt während des Einförderns des flüssigen Heliums in den Anwendungskryostaten 102 keinerlei gasförmiges Helium aus dem Anwendungskryostaten 102 aus.

Sollte der Druck $p_{anwend}$ unter $p_{anwend}^{soll}$ sinken, erhöht die Steuereinrichtung 8 die Heizleistung am Heizer 7, so dass zusätzliches Helium im Vorratsdewar 1 verdampft wird, der Druck $p_{vorrat}$ im Vorratsdewar ansteigt, der Fluss an flüssigem Helium durch die Transferleitung 9 erhöht wird, und der Gasdruck im Anwendungskryostaten 102 ansteigt. Sollte der Druck $p_{anwend}$ über $p_{anwend}^{soll}$ steigen, senkt die Steuereinrichtung 8 die Heizleistung am Heizer 7 oder schaltet ihn ganz ab, so dass weniger oder gar kein Helium im Vorratsdewar 1 verdampft wird, der Druck im Vorratsdewar 1 (auch in Folge der nachlaufenden Ausförderung von flüssigem Helium 5) absinkt, der Fluss an flüssigem Helium durch die Transferleitung 9 erniedrigt wird, und der Gasdruck im Anwendungskryostaten 102 absinkt.

In der gezeigten Ausführungsform wird die Kühlleistung des Kryokühlers 29 während des Transfers von flüssigem Helium konstant gehalten.

In der gezeigten Ausführungsform ist im Anwendungskryostaten 102 eine supraleitende Magnetspule 32 (auch kurz als Magnet bezeichnet) angeordnet. Im Normalbetrieb ragt ein NMR-Probenkopf 33 in eine Raumtemperaturbohrung (nicht näher dargestellt) des Anwendungskryostaten 102 ein, so dass eine Messprobe 34 im Magnetfeld des Magneten 32 in dessen Magnetbohrung einer NMR-Messung unterzogen werden kann. Man beachte, dass im Normalbetrieb die Transferleitung 9 und der Kühlstab 16 aus dem Zugangsrohr 15a herausgezogen sind, und nur im Nachfüllbetrieb die Transferleitung 9 und der Kühlstab 16 in das Zugangsrohr 15a eingesteckt sind (letzteres dargestellt in Fig. 1).

Im Anwendungskryostat 102 und im Vorratsdewar 1 können zudem Füllstandssensoren vorgesehen sein, die von der Steuereinrichtung 8 ausgelesen werden (nicht näher dargestellt).

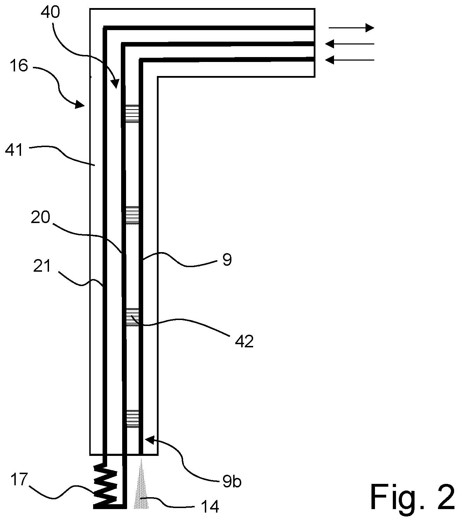

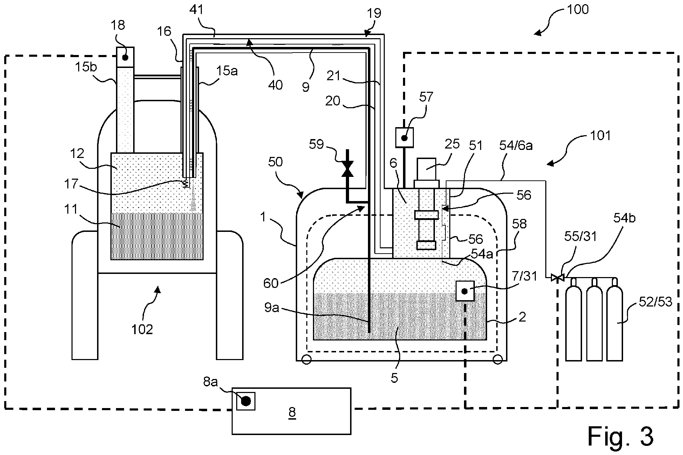

Die **Figur 2** illustriert einen hinteren Abschnitt eines Leitungsbündels 40, das im Rahmen der Erfindung an einer erfindungsgemäßen Vorrichtung zum Transfer von flüssigem Helium eingesetzt werden kann (vgl. hierzu auch Fig. 3).

Im Leitungsbündel 40 verlaufen die Vorlaufleitung 20 und die Rücklaufleitung 21 des Kühlkreislaufs für den Kondensationswärmetauscher 17 sowie die Transferleitung 9 für das flüssige Helium 14, das am zweiten Transferleitungsende 9b in den Anwendungskryostaten ausfließt. Das Leitungsbündel 40 bildet ein gemeinsames Isolationsvakuum 41 für die Leitungen 9, 20, 21 aus. Zwischen der Transferleitung 9 und der Vorlaufleitung 20 sind mehrere Kopplungsbrücken 42 aus gut wärmeleitendem Material, beispielsweise aus hochreinem Kupfer, eingerichtet, durch die eine thermische Kopplung zwischen der Vorlaufleitung 20 und der Transferleitung 9 eingerichtet ist. Dadurch ist es

**EP 4 575 352 A1**

insbesondere möglich, mit der Vorlaufleitung 20 vor Beginn des Transfers von flüssigem Helium die Transferleitung 9 vorzukühlen.

Der vertikal verlaufende Teil des Leitungsbündels 40 bildet hier einen leicht handhabbaren Kältestab 16 aus. Man beachte, dass das Leitungsbündel jenseits des Kühlstabs bevorzugt flexibel ausgebildet ist. Das Leitungsbündel kann eine so genannte Superisolation aufweisen. Zudem sind Abstandhalter von geringer Wärmeleitfähigkeit vorgesehen, um die Leitungen von der äußeren Isolationhülle beabstandet zu halten.

Die **Figur 3** zeigt schematisch eine zweite Ausführungsform eines erfindungsgemäßen Anwendungssystems 100, umfassend eine Vorrichtung 101 zum Transfer von flüssigem Helium und ein Anwendungskryostaten 102. Das Anwendungssystem 100 entspricht weitgehend dem Anwendungssystem von Fig. 1, so dass im Folgenden nur die wesentlichen Unterschiede erläutert werden. Zur Vereinfachung sind der Kompressor und Teile der das Kühlmittel führenden Leitungen in Fig. 3 nicht näher dargestellt.

In der Ausführungsform von Fig. 3 ist ein gemeinsamer Vorrats-Kryostat 50 eingerichtet, in welchem sowohl der Kaltkopf 25 als auch der Heliumbehälter 2 angeordnet sind. Der Kaltkopf 25 ist dabei in einem Aufnahmebereich 51 angeordnet, der zum Heliumbehälter 2 hin offen ist, so dass sich das gasförmige Helium 6 im oberen Teil des Heliumbehälters 2 und im Aufnahmebereich 51 verteilt. Der Vorrats-Kryostat 50 weist hier einen Strahlungsschild 58 auf, der an eine wärmere Kühlstufe des Kaltkopfs 25 thermisch gekoppelt ist (Kopplung nicht näher dargestellt).

Von einem Heliumgasspeicher 52, der als Helium-Druckgasspeicher 53 ausgebildet ist, führt eine Heliumgasleitung 54 in den Vorratsdewar 1. Ein erstes Heliumgasleitungs-Ende 54a ragt in den oberen Teil des Heliumbehälters 2, und ein zweites Heliumgasleitungs-Ende 54b ist an den Helium-Druckgasspeicher 53 angeschlossen. Der Helium-Druckgasspeicher 53 kann transportabel ausgebildet sein, beispielsweise mit Rollen (nicht näher dargestellt).

Die Heliumgasleitung 54 hat nahe ihres zweiten Heliumgasleitungs-Endes 54b ein Stellventil 55, welches mit der Steuereinrichtung 8 automatisch betätigbar ist, hier mit einem Elektromotor (nicht näher dargestellt).

Die Heliumgasleitung 54 führt durch den Aufnahmebereich 51 am Kaltkopf 25 vorbei und ist an die beiden Kaltstufen des Kaltkopfes 25 mittels eines Heliumzufuhr-Wärmetauschers 56 thermisch gekoppelt. Durch die Heliumgasleitung 54 in den Vorratsdewar 1 einströmendes Heliumgas 6a (oder auch bereits im Vorratsdewar 1 vorhandenes Heliumgas 6) kann mit dem Kaltkopf 25 verflüssigt werden.

Man beachte, dass das Heliumgas 6a vor der Verflüssigung gereinigt werden sollte, beispielsweise mittels einer Kältefalle (nicht näher dargestellt); hierbei kann beispielsweise die in der DE 10 2021 205 423 A1 beschriebene Vorrichtung eingesetzt werden.

In der gezeigten Ausführungsform ist zudem ein Drucksensor 57 vorgesehen, mit dem ein Druck $p_{vorrat}$ im Vorratsdewar 1 gemessen und von der Steuereinrichtung 8 überwacht wird; die Steuereinrichtung 8 sorgt dafür, dass $p_{vorrat}$ jederzeit oberhalb von $p_{atm}$ bleibt (siehe auch unten), wodurch ein Einsaugen von Umgebungsluft in den Vorratsdewar 1 verhindert wird. Zudem überwacht die Steuereinrichtung 8 auch den Druck $p_{anwend}$ im Anwendungskryostaten 102 mit dem Drucksensor 18. Weiterhin kann die Steuereinrichtung 8 den Heizer 7 im Vorratsdewar 1 ansteuern.

Die Steuereinrichtung 8 kann hier den Heizer 7 (siehe oben) oder auch das Stellventil 55 jeweils als Einrichtung 31 zur Erzeugung einer Druckdifferenz zwischen dem Vorratsdewar 1 und dem Anwendungskryostaten 102 nutzen. Durch Vergrö-βerung des Öffnungsquerschnitts des Stellventils 55 kann zusätzliches Helium (Heliumgas und/oder verflüssigtes Helium) in den Vorratsdewar 1 eingeleitet werden, was den Druck $p_{vorrat}$ im Vorratsdewar 1 erhöht. Durch Verkleinerung des Öffnungsquerschnitts des Stellventils 55 oder Schließen des Stellventils 55 kann (bei nachlaufendem Ausfördern von flüssigem Helium durch die Transferleitung 9 in den Anwendungskryostaten) der Druck $p_{vorrat}$ im Vorratsdewar 1 abgesenkt werden.

Die Vorlaufleitung 20, die Rücklaufleitung 21 und die Transferleitung 9 verlaufen hier zwischen Vorratsdewar 1 und Anwendungskryostat 102 als Leitungsbündel 40 in einer gemeinsamen Vakuumisolation 41 (vgl. Fig. 2). Zudem verfügt die Transferleitung 9 nahe ihres ersten Transferleitungs-Endes 9a über eine Verzweigung 60 zu einem Spülventil 59, wobei die Verzweigung 60 hier innerhalb des gemeinsamen Vorrats-Kryostaten 50 liegt. Durch das Spülventil 59 kann die Transferleitung 9 zwischen dem zweiten Transferleitungs-Ende 9b bis zur Verzweigung 60 mit Heliumgas 12 (das aus dem Anwendungskryostaten 102 stammt) gespült werden, was vor Beginn des Transfers von flüssigem Helium durch die Transferleitung 9 erfolgt; man beachte, dass hierfür $p_{anwend} > p_{atm}$ ist. Um Heliumverluste komplett zu eliminieren, kann der Ausgang des Spülventils 59 mit einem Heliumrückgewinnungssystem verbunden werden; die Luft, die ins Heliumrückgewinnungssystem gespült wird, kann bei der Rückverflüssigung des Heliums aus dem Rückgewinnungssystem in einer vorgeschalteten Kältefalle abgeschieden werden (Heliumrückgewinnungssystem und Kältefalle nicht näher dargestellt).

*Erfindungsgemäßer Verfahrensablauf*

Im Folgenden soll beispielhaft der Ablauf beim Nachfüllen von flüssigem Helium aus dem Vorratsdewar 1 in den Anwendungskryostaten 102 im Rahmen eines erfindungsgemäßen Verfahrens erläutert werden. Der beispielhafte Ablauf kann insbesondere an einem Anwendungssystem 100 wie in Figur 3 dargestellt stattfinden. Die Schritte 2 bis 6 können einem Transferbetrieb zugeordnet werden, und der Schritt 7 einem Normalbetrieb des Anwendungskryostaten 102. Schritt 1 kann parallel zum Normalbetrieb oder als Teil eines Transferbetriebs stattfinden.

Schritt 1) Heliumgas wird aus dem Helium-Druckgasspeicher 53 über die Heliumleitung 54 dem Vorratsdewar 1 zugeleitet, wobei es vom Kaltkopf 25 verflüssigt wird. Flüssiges Helium 5 sammelt sich im Heliumbehälter 2.

Schritt 2) Sobald die Verflüssigung abgeschlossen ist (z.B. weil der Heliumbehälter 2 voll oder der Helium-Druckgasspeicher 53 leer ist), kann der Transfer des flüssigen Heliums 5 vorbereitet werden. Der Benutzer führt dafür zunächst den Kühlstab 16 mit der Transferleitung 9 und dem Kondensationswärmetauscher 17 in den Anwendungskryostaten 102 in das Zugangsrohr 15a ein.

Schritt 3) Das Spülventil 59 wird geöffnet, und Heliumgas aus dem Anwendungskryostaten 102 drückt Luft durch das Spülventil 59 aus der Transferleitung 9 heraus. Wenn die vorhandene Luft entwichen ist, wird das Spülventil 59 geschlossen.

Schritt 4) Dann wird das Kühlkreislaufventil (Bzz. 19a in Fig. 1) für das Kühlmittel geöffnet, wodurch ein Teil des vom Kompressor (Bzz. 28 in Fig. 1) bereitgestellten Gasstroms abgezweigt wird und die Zirkulation des Kühlmittels im Kühlkreislauf 19 bzw. durch den Kondensationswärmetauscher 17 hindurch aktiviert wird. Da die Vorlaufleitung 20 thermisch mit der Transferleitung 9 verbunden ist, kühlt dabei die Transferleitung 9 ab.

Schritt 4) Sobald der Kondensationswärmetauscher 17 und die Transferleitung 9 kalt sind, wird der Transfer von flüssigem Helium ("Heliumtransfer") gestartet. Dies kann entweder von selbst geschehen, wenn der Druck im Heliumtank 10 des Anwendungskryostaten 102 durch die einsetzende Kondensation absinkt, oder der Druck im Vorratsdewar 1 wird aktiv erhöht, z.B. mit dem Heizer 7 oder mit zugeleitetem Heliumgas 6a aus dem Helium-Druckgasspeicher 53.

Schritt 5) Der Heliumtransfer wird nun von der Steuereinrichtung 8 so gesteuert, dass die Transferrate des flüssigen Heliums durch die Transferleitung 9 der Rate entspricht, mit der gasförmiges Helium 12 im Anwendungskryostaten 102 kondensiert, sodass während des Heliumtransfers kein Heliumgas 12 aus dem Anwendungskryostaten 102 entweicht. Entsprechend kann der Heliumtransfer erfindungsgemäß so durchgeführt werden, dass kein Speicherballon nötig ist, um den Heliumtransfer verlustfrei durchzuführen.

Schritt 6) Sobald der Heliumtransfer abgeschlossen ist (z.B. weil der Anwendungskryostat 102 vollständig mit flüssigem Helium 11 gefüllt ist oder das flüssige Helium 5 im Vorratsdewar 1 erschöpft ist), entfernt der Benutzer den Kühlstab 16 mit der Transferleitung 9 und dem Kondensationswärmetauscher 17 aus dem Anwendungskryostaten 102.

Schritt 7) Nun können unter Nutzung des Anwendungskryostaten 102, und insbesondere des im Anwendungskryostaten 102 enthaltenen NMR-Magneten (Bzz. 32 in Fig. 1) NMR-Messungen weitergeführt werden, nur wenige Stunden nach Beginn des Heliumtransfers. Im Vergleich zu einem herkömmlichen Heliumtransfer mit Austritt von gasförmigem Helium durch eines der Zugangsrohre 15a, 15b erfolgt die Stabilisierung des Anwendungskryostaten 102 im Rahmen der Erfindung deutlich schneller, da keine großen Mengen kalten Gases durch die Zugangsrohre (Aufhängerohre) 15a, 15b entwichen sind (Letzteres führt üblicherweise zu einem starken Abkühlen der Zugangsrohre während eines herkömmlichen Heliumtransfers, und während der Rückkehr in das thermische Gleichgewicht ist das Magnetfeld instabil).

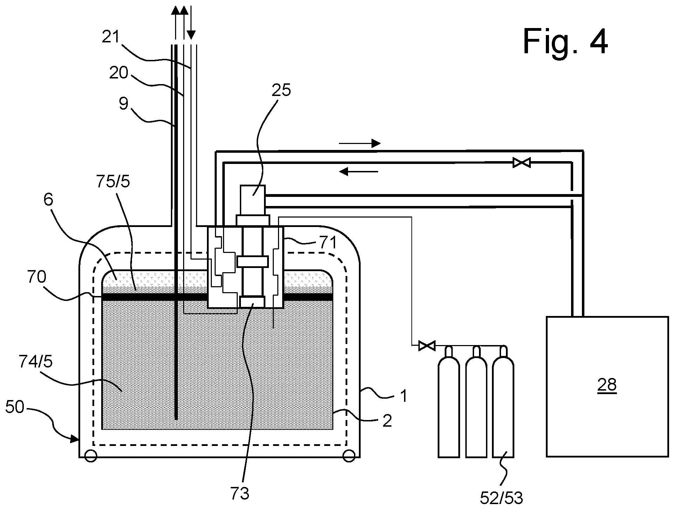

Die **Figur 4** zeigt eine alternative Bauform des Vorratsdewars 1 für die Erfindung, die beispielsweise in der Ausführungsform des Anwendungssystems von Fig. 3 eingesetzt werden kann. Es werden nur die wesentlichen Unterschiede zur Bauform von Fig. 3 erläutert.

In der in Fig. 4 gezeigten Bauform ist im Heliumbehälter 2 des Vorratsdewars 1 eine Thermalbarriere 70 angeordnet. Die Thermalbarriere 70 ist druckdurchlässig (also von flüssigem Helium durchströmbar), aber thermisch isolierend. Die Thermalbarriere 70 kann insbesondere wie in der DE 40 39 365 A1 beschrieben ausgebildet sein.

Der Kaltkopf 25 ist in einem abgeschlossenen Vakuumbehälter 71 angeordnet, wobei der Vakuumbehälter 71 bis jenseits (unter) die Thermalbarriere 70 reicht. Die unterste (kälteste) Kühlstufe 73 des Kaltkopfs 25 kann dadurch das flüssige Helium 74 unterhalb der Thermalbarriere 70 kühlen. Dieses flüssige Helium 74 unterhalb der Thermalbarriere 70 ist unterkühlt und weist hier eine Temperatur von ca. 3,7 K auf. Das unterkühlte flüssige Helium 74 wird in seiner Gesamtheit auch als unterkühltes flüssiges Heliumvolumen 74 bezeichnet. Oberhalb der Thermalbarriere 70 befindet sich gesättigtes flüssiges Helium 75 bei einer Temperatur von ca. 4,2 K; das gesättigte flüssige Helium 75 wird in seiner Gesamtheit auch als gesättigtes flüssiges Heliumvolumen 75 bezeichnet. Das gasförmige Helium 6 darüber hat ebenfalls eine Temperatur von ca. 4,2 K und steht unter dem Druck $p_{vorrat}$ von ca. 1,08 bar.

Die Transferleitung (Leitungsrohr) 9 ragt bis kurz vor den Boden des Heliumbehälters 2 tief in den Bereich des unterkühlten flüssigen Heliums 74. In dem Abschnitt, in welchem die Transferleitung 9 durch den Bereich des gesättigten Heliumvolumens 75 führt, ist die Transferleitung 9 vom gesättigten Heliumvolumen 75 thermisch isoliert (nicht näher dargestellt). Entsprechend wird im Rahmen des Heliumtransfers unterkühltes flüssiges Helium 74 durch die Transferleitung 9 in den Anwendungskryostaten gefördert.

Durch das unterkühlte flüssige Helium 74, das in den Anwendungskryostaten eingefördert wird, kann dem Anwendungskryostaten Wärmeenergie entzogen werden, wenn das unterkühlte flüssige Helium sich wieder auf 4,2 K erwärmt. Es muss dann weniger Kühlleistung am Kondensationswärmetauscher aufgebracht werden, um gasförmiges Helium am Kondensationswärmetauscher zu kondensieren. Wenn beispielsweise 100 l flüssigen Heliums (12,5 kg) mit einer Temperatur von 3,7 K transferiert werden, stehen ca. 26,3 kJ zusätzliche Kälteenergie zur Verfügung, die für die benötigten ca. 34 kJ für die Kondensationswärme (siehe oben) genutzt werden können. Allerdings wird die Bereitstellung von unterkühltem flüssigem Helium 74 energetisch umso aufwändiger, je tiefer die Temperatur des unterkühlten flüssigen Heliums 74 ist.

Die Vorlaufleitung 20 des Kühlkreislaufs für den Kondensationswärmetauscher im Anwendungskryostaten verläuft durch den Bereich des unterkühlten flüssigen Heliums 74. Entsprechend kann über das Kühlmittel ein besonders effizienter Abtransport von Wärmeenergie vom Kondensationswärmetauscher erfolgen.

Man beachte, dass unterkühltes Helium für die Erfindung auch beispielsweise mittels Entspannung von Helium in einer Drossel auf niedrigen Druck erfolgen kann (nicht näher dargestellt)

Zusammenfassend betrifft die Erfindung eine Vorrichtung (101) zum Transfer von flüssigem Helium (14) in einen Anwendungskryostaten (102), umfassend

- einen Vorratsdewar (1),
- eine Transferleitung (9) umfassend ein erstes Transferleitungs-Ende (9a) im Vorratsdewar (1) und ein zweites Transferleitungs-Ende (9b) zum Einstecken in einen Anwendungskryostaten (102),
- eine Einrichtung (31) zur Erzeugung einer Druckdifferenz zwischen Vorratsdewar (1) und Anwendungskryostat (102), gekennzeichnet durch
- einen Kondensationswärmetauscher (17) zum Kondensieren von Heliumgas (12) zu flüssigem Helium (11), zum Einstecken in den Anwendungskryostaten (102),
- einen Kryokühler (29) zum Kühlen des Kondensationswärmetauschers (17), und
- eine Steuereinrichtung (8), mit einem Messeingang (18a) für einen Drucksensor (18) zur Messung des Gasdrucks im Anwendungskryostaten (102) und einen Steuerausgang (31a) für die Einrichtung (31) zur Erzeugung einer Druckdifferenz, wobei die Steuereinrichtung (8) dazu programmiert ist, die Einrichtung (31) zur Erzeugung einer Druckdifferenz so zu steuern, dass ein Volumen von pro Zeiteinheit durch die Transferleitung (9) transferiertem flüssigen Helium (14) näherungsweise gleich ist der Volumenänderung des Heliums, welches pro Zeiteinheit am Kondensationswärmetauscher (17) von Heliumgas (12) zu flüssigem Helium (11) kondensiert. Mit der Vorrichtung werden Heliumverluste beim Transfer von flüssigem Helium auf einfache Weise minimiert.

Bezugszeichenliste

| 1 | Vorratsdewar |
| 2 | Heliumbehälter |
| 3 | Isolationsvakuum (am Vorratsdewar) |
| 4 | Umgebung / umgebende Atmosphäre |
| 5 | flüssiges Helium (im Vorratsdewar) |
| 6 | gasförmiges Helium (im Vorratsdewar) |
| 6a | gasförmiges Helium (aus Heliumgasspeicher) |
| 7 | elektrischer Heizer (im Vorratsdewar) |
| 8 | elektronische Steuereinrichtung |
| 8a | Drucksensor für die umgebende Atmosphäre |
| 9 | Transferleitung für flüssiges Helium |
| 9a | erstes Transferleitungs-Ende (eingesteckt in Vorratsdewar) |
| 9b | zweites Transferleitungs-Ende (eingesteckt in Anwendungskryostaten) |
| 10 | Heliumtank |
| 11 | flüssiges Helium (im Anwendungskryostaten) |
| 12 | gasförmiges Helium (im Anwendungskryostaten) |
| 13 | Isolationsvakuum (am Anwendungskryostaten) |
| 14 | (ausfließendes/transferiertes) flüssiges Helium |
| 15a | erstes/gemeinsames Zugangsrohr |
| 15b | zweites Zugangsrohr |
| 16 | Kühlstab |
| 17 | Kondensationswärmetauscher |
| 18 | Drucksensor für Anwendungskryostaten |
| 18a | Messeingang (für Drucksensor 18) |
| 19 | Kühlkreislauf |
| 19a | Kühlkreislaufventil |

EP 4 575 352 A1

| 20 | Vorlaufleitung für Kühlmittel |
| 21 | Rücklaufleitung für Kühlmittel |
| 22 | Vakuumisolierung (Vorlaufleitung und Rücklaufleitung) |
| 23 | Vakuumisolierung (Transferleitung) |
| 25 | Kaltkopf |
| 25a | Kaltkopf-Wärmetauscher (für Kühlkreislauf) |
| 26 | Kompressor-Vorlaufleitung |
| 27 | Kompressor-Rücklaufleitung |
| 28 | Kompressor |
| 29 | Kryokühler |
| 30 | Kryokühler-Kryostat |
| 31 | Einrichtung zur Erzeugung einer Druckdifferenz |
| 31a | Steuerausgang (für Einrichtung 31) |
| 32 | supraleitende Magnetspule/Magnet |
| 33 | NMR-Probenkopf |
| 34 | Messprobe |
| 35, 36 | Kaltkopfleitungen |
| 37 | Rollen |
| 40 | Leitungsbündel |
| 41 | gemeinsames Isolationsvakuum |
| 42 | Kopplungsbrücken |
| 50 | gemeinsamer Vorrats-Kryostat |
| 51 | Aufnahmebereich |
| 52 | Heliumgasspeicher |
| 53 | Helium-Druckgasspeicher |
| 54 | Heliumgasleitung |
| 54a | erstes Heliumgasleitungs-Ende |
| 54b | zweites Heliumgasleitungs-Ende |
| 55 | Stellventil |
| 56 | Heliumzufuhr-Wärmetauscher |
| 57 | Drucksensor für Vorratsdewar |
| 58 | Strahlungsschild |
| 59 | Spülventil |
| 60 | Verzweigung für Spülventil |
| 70 | Thermalbarriere |
| 71 | Vakuumbehälter |
| 73 | unterste/kälteste Kühlstufe |
| 74 | unterkühltes flüssiges Helium/Heliumvolumen |
| 75 | gesättigtes flüssiges Helium/Heliumvolumen |
| 100 | Anwendungssystem |
| 101 | Vorrichtung zum Transfer von flüssigem Helium |
| 102 | Anwendungskryostat |

**Patentansprüche**

1. Vorrichtung (101) zum Transfer von flüssigem Helium (14) in einen Anwendungskryostaten (102), umfassend

- einen Vorratsdewar (1) für flüssiges Helium (5),
- eine Transferleitung (9) für flüssiges Helium (14), zum Überführen von flüssigem Helium (5) aus dem Vorratsdewar (1) in den Anwendungskryostaten (102), umfassend ein erstes Transferleitungs-Ende (9a), angeordnet im Vorratsdewar (1), und ein zweites Transferleitungs-Ende (9b), zum Einstecken in den Anwendungskryostaten (102),
- eine Einrichtung (31) zur Erzeugung einer Druckdifferenz zwischen dem Vorratsdewar (1) und dem Anwendungskryostaten (102),
**dadurch gekennzeichnet,**
**dass** die Vorrichtung (101) weiterhin umfasst
- einen Kondensationswärmetauscher (17) zum Kondensieren von Heliumgas (12) zu flüssigem Helium (11), zum Einstecken in den Anwendungskryostaten (102),

- einen Kryokühler (29) zum Kühlen des Kondensationswärmetauschers (17), und
- eine Steuereinrichtung (8), aufweisend zumindest einen Messeingang (18a) für einen Drucksensor (18) zur Messung des Gasdrucks im Anwendungskryostaten (102) und einen Steuerausgang (31a) für die Einrichtung (31) zur Erzeugung einer Druckdifferenz, wobei die Steuereinrichtung (8) dazu programmiert ist, die Einrichtung (31) zur Erzeugung einer Druckdifferenz so zu steuern, dass ein Volumen von pro Zeiteinheit durch die Transferleitung (9) transferiertem flüssigen Helium (14) näherungsweise gleich ist der Volumenänderung des Heliums, welches pro Zeiteinheit am Kondensationswärmetauscher (17) von Heliumgas (12) zu flüssigem Helium (11) kondensiert.

2. Vorrichtung (101) nach Anspruch 1, **dadurch gekennzeichnet, dass** die Steuereinrichtung (8) dazu programmiert ist, während des Transfers von flüssigem Helium (14) in den Anwendungskryostaten (102) den Druck ($p_{an-wend}$) im Anwendungskryostaten (102) näherungsweise konstant zu halten.

3. Vorrichtung (101) nach einem der vorhergehenden Ansprüche, **dadurch gekennzeichnet,**

   **dass** die Steuereinrichtung (8) einen Drucksensor (8a) zur Messung des umgebenden Atmosphärendrucks ($p_{atm}$) aufweist,
   und **dass** die Steuereinrichtung (8) dazu programmiert ist, den Druck ($p_{an-wend}$) im Anwendungskryostaten (102) jederzeit oberhalb eines umgebenden Atmosphärendrucks ($p_{atm}$) zu halten, insbesondere durch eine entsprechende Ansteuerung der Einrichtung (31) zur Erzeugung einer Druckdifferenz.

4. Vorrichtung (101) nach einem der vorhergehenden Ansprüche, **dadurch gekennzeichnet, dass** die Einrichtung (31) zur Erzeugung einer Druckdifferenz ein Stellventil (55) in einer Heliumgasleitung (54) umfasst, mit der Heliumgasleitung (54) umfassend ein erstes Heliumgasleitungs-Ende (54a) angeschlossen an den Vorratsdewar (1) und ein zweites Heliumgasleitungs-Ende (54b) zum Anschließen an einen Heliumgasspeicher (52), insbesondere Helium-Druckgasspeicher (53).

5. Vorrichtung (101) nach einem der vorhergehenden Ansprüche, **dadurch gekennzeichnet, dass** die Einrichtung (31) zur Erzeugung einer Druckdifferenz einen elektrischen Heizer (7) im Vorratsdewar (1) umfasst.

6. Vorrichtung (101) nach einem der vorhergehenden Ansprüche, **dadurch gekennzeichnet, dass** die Vorrichtung (101) weiterhin umfasst

   - einen geschlossenen Kühlkreislauf (19) eines Kühlmittels, umfassend eine Vorlaufleitung (20) von einem Kaltkopf (25) des Kryokühlers (29) zum Kondensationswärmetauscher (17) und eine Rücklaufleitung (21) vom Kondensationswärmetauscher (17) zum Kaltkopf (25) des Kryokühlers (29),

      wobei der Kryokühler (29) dazu eingerichtet ist, das Kühlmittel mit dem Kaltkopf (25) direkt oder indirekt zu kühlen,
      insbesondere wobei der Kaltkopf (25) des Kryokühlers (29) separat vom Anwendungskryostaten (102) angeordnet ist.

7. Vorrichtung (101) nach Anspruch 6, **dadurch gekennzeichnet, dass** ausgehend vom Vorratsdewar (1) die Vorlaufleitung (20), die Rücklaufleitung (21) und die Transferleitung (9) als Leitungsbündel (40) in einem gemeinsamen Isolationsvakuum (41) verlaufen.
   insbesondere wobei in dem gemeinsamen Isolationsvakuum (41) die Vorlaufleitung (20) und die Transferleitung (9) thermisch miteinander gekoppelt sind, bevorzugt durch eine Vielzahl von Kopplungsbrücken (42).

8. Vorrichtung (101) nach einem der vorhergehenden Ansprüche, **dadurch gekennzeichnet, dass** die Vorrichtung (101) weiterhin einen Heliumgasspeicher (52) umfasst, der über eine Heliumgasleitung (54) mit dem Vorratsdewar (1) verbunden ist,
   insbesondere wobei der Heliumgasspeicher (52) ein Helium-Druckgasspeicher (53) ist.

9. Vorrichtung (101) nach einem der vorhergehenden Ansprüche, **dadurch gekennzeichnet, dass** ein Kaltkopf (25) des Kryokühlers (29) und ein Heliumbehälter (2) des Vorratsdewars (1) in einem gemeinsamen Vorrats-Kryostaten (50) angeordnet sind,
   wobei der Kaltkopf (25) des Kryokühlers (29) dazu eingerichtet ist, im Vorratsdewar (1) Heliumgas (6, 6a) in flüssiges Helium (5) zu verflüssigen.

10. Vorrichtung (101) nach Anspruch 9, **dadurch gekennzeichnet, dass** der Heliumbehälter (2) und der Kaltkopf (25) dazu eingerichtet sind, im Heliumbehälter (2) ein flüssiges unterkühltes Heliumvolumen (74) bereitzustellen.

11. Vorrichtung (101) nach Anspruch 10, **dadurch gekennzeichnet, dass** im Heliumbehälter (2) eine Thermalbarriere (70) angeordnet ist, mit der das unterkühlte Heliumvolumen (74) unterhalb der Thermalbarriere (70) von einem flüssigen gesättigten Heliumvolumen (75) oberhalb der Thermalbarriere (70) getrennt wird.

12. Anwendungssystem (100), umfassend eine Vorrichtung (101) nach einem der vorhergehenden Ansprüche sowie einen Anwendungskryostaten (102), wobei die Transferleitung (9) und der Kondensationswärmetauscher (17) in den Anwendungskryostaten (102) eingesteckt sind, insbesondere in ein gemeinsames Zugangsrohr (15a) des Anwendungskryostaten (102), und wobei der Anwendungskryostat (102) eine supraleitende Magnetspule (32) enthält und ein NMR-Probenkopf (33) in eine Magnetbohrung der Magnetspule (32) einragt.

13. Verfahren zum Transfer von flüssigem Helium (14) in einen Anwendungskryostaten (102),

insbesondere unter Verwendung einer Vorrichtung (101) oder eines Anwendungssystems (100) nach einem der vorhergehenden Ansprüche, wobei eine Transferleitung (9) für flüssiges Helium (14) mit einem ersten Transferleitungs-Ende (9a) an einen Vorratsdewar (1) enthaltend flüssiges Helium (5) angeschlossen ist und mit einem zweiten Transferleitungs-Ende (9b) in den Anwendungskryostaten (102) eingesteckt ist,
wobei von dem Vorratsdewar (1) über die Transferleitung (9) flüssiges Helium (14) in den Anwendungskryostaten (102) transferiert wird,
wobei mit einer Einrichtung (31) zur Veränderung einer Druckdifferenz zwischen dem Vorratsdewar (1) und dem Anwendungskryostaten (102) ein Fluss an flüssigem Helium (14) durch die Transferleitung (9) eingestellt wird, **dadurch gekennzeichnet,**
**dass** ein Kondensationswärmetauscher (17), der mit einem Kryokühler (29) gekühlt wird, in den Anwendungskryostaten (102) eingesteckt ist und im Anwendungskryostaten (102) gasförmiges Helium (12) zu flüssigem Helium (11) verflüssigt,
und **dass** eine Steuereinrichtung (8) einen Druck ($p_{anwend}$) im Anwendungskryostaten (102) misst und die Einrichtung (31) zur Veränderung einer Druckdifferenz so ansteuert, dass ein Volumen von pro Zeiteinheit durch die Transferleitung (9) transferiertem flüssigen Helium (14) näherungsweise gleich ist der Volumenänderung des Heliums, welches pro Zeiteinheit am Kondensationswärmetauscher (17) von Heliumgas (12) zu flüssigem Helium (11) kondensiert.

14. Verfahren nach Anspruch 13, **dadurch gekennzeichnet, dass** die Steuereinrichtung (8) während des Transfers von flüssigem Helium (14) in den Anwendungskryostaten (102) den Druck ($p_{anwend}$) im Anwendungskryostaten (102) näherungsweise konstant hält.

15. Verfahren nach Anspruch 13 oder 14, **dadurch gekennzeichnet, dass** während des Transfers von flüssigem Helium (14) kein Abfluss von gasförmigem Helium (12) aus dem Anwendungskryostaten (102) stattfindet.

16. Verfahren nach einem der Ansprüche 13 bis 15, **dadurch gekennzeichnet, dass** die Steuereinrichtung (8) einen umgebenden Atmosphärendruck ($p_{atm}$) misst, und dass die Steuereinrichtung (8) den Druck ($p_{anwend}$) im Anwendungskryostaten (102) jederzeit oberhalb des umgebenden Atmosphärendrucks ($p_{atm}$) hält, insbesondere durch eine entsprechende Ansteuerung der Einrichtung (31) zur Erzeugung einer Druckdifferenz.

17. Verfahren nach einem der Ansprüche 13 bis 16, **dadurch gekennzeichnet, dass** die Steuereinrichtung (8) als Einrichtung (31) zur Veränderung einer Druckdifferenz ein Stellventil (55) in einer Heliumgasleitung (54) ansteuert, die von einem Heliumgasspeicher (52), insbesondere Helium-Druckgasspeicher (53), zum Vorratsdewar (1) führt und/oder dass die Steuereinrichtung (8) als Einrichtung (31) zur Veränderung einer Druckdifferenz einen elektrischen Heizer (7) im Vorratsdewar (1) ansteuert.

18. Verfahren nach einem der Ansprüche 13 bis 17, **dadurch gekennzeichnet, dass** ein Kühlmittel in einem geschlossenen Kühlkreislauf (19) durch eine Vorlaufleitung (20) von einem Kaltkopf (25) des Kryokühlers (29) zum Kondensationswärmetauscher (17) und durch eine Rücklaufleitung (21) zurück zum Kühlkopf (25) des Kryokühlers (29) geführt wird, wobei der Kaltkopf (25) des Kryokühlers (29) das Kühlmittel direkt oder indirekt kühlt, insbesondere wobei der Kaltkopf (25) separat vom Anwendungskryostaten (102) angeordnet ist.

19. Verfahren nach Anspruch 18, **dadurch gekennzeichnet, dass** die Transferleitung (9) zwischen dem Vorratsdewar (1) und dem Anwendungskryostaten (102) mit der Vorlaufleitung (20) thermisch koppelt, und dass vor Beginn eines Transfers von flüssigem Helium (14) durch die Transferleitung (9) die Transferleitung (9) zunächst mit dem Kühlmittel in der Vorlaufleitung (20) vorgekühlt wird.

20. Verfahren nach einem der Ansprüche 13 bis 19, **dadurch gekennzeichnet, dass** ein Kaltkopf (25) des Kryokühlers (29) und ein Heliumbehälter (2) des Vorratsdewars (1) in einem gemeinsamen Vorrats-Kryostaten (50) angeordnet sind,
und dass vor Beginn des Transfers von flüssigem Helium (14) gasförmiges Helium (6a) aus einem Heliumgasspeicher (52), insbesondere Helium-Druckgasspeicher (53), dem Vorratsdewar (1) zugeführt wird und mit dem Kaltkopf (25) im Vorratsdewar (1) gasförmiges Helium (6, 6a) in flüssiges Helium (5) kondensiert wird.

21. Verfahren nach einem der Ansprüche 13 bis 20, **dadurch gekennzeichnet, dass** in einem Heliumbehälter (2) des Vorratsdewars (1) ein flüssiges unterkühltes Heliumvolumen (74) bereitgestellt wird,
und dass das durch die Transferleitung (9) transferierte flüssige Helium (14) aus dem flüssigen unterkühlten Heliumvolumen (74) entnommen wird.

22. Verfahren nach einem der Ansprüche 13 bis 21, **dadurch gekennzeichnet, dass** der Anwendungskryostat (102) im Wechsel in einem Normalbetrieb für eine Anwendung eingesetzt wird und in einem Nachfüllbetrieb mit flüssigem Helium (14) befüllt wird,

wobei während des Normalbetriebs der Kondensationswärmetauscher (17) und das zweite Transferleitungs-Ende (9b) nicht in den Anwendungskryostaten (102) eingesteckt sind, und während des Nachfüllbetriebs der Kondensationswärmetauscher (17) und das zweite Transferleitungs-Ende (9b) in den Anwendungskryostaten (102) eingesteckt sind,
und dass im Anwendungskryostaten (102) eine supraleitende Magnetspule (32) angeordnet ist, und während des Normalbetriebs als Anwendung mit einem NMR-Probenkopf (33) NMR-Messungen an Proben (34) durchgeführt werden, die in einer Magnetbohrung der supraleitenden Magnetspule (32) angeordnet sind.

Fig. 1

Fig. 2

Fig. 3

Fig. 4

Europäisches
Patentamt

European
Patent Office

Office européen
des brevets

**EUROPÄISCHER RECHERCHENBERICHT**

Nummer der Anmeldung

EP 24 21 9235

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2022/397311 A1 (ITO SATOSHI [JP]) 15. Dezember 2022 (2022-12-15) * Absatz [0009] - Absatz [0089]; Abbildungen 1-9 * | 1-22 | INV. F25B9/00 F25B9/14 F17C13/00 F17C5/04 |
| | ----- | | |
| A | JP H04 302404 A (TOSHIBA CORP) 26. Oktober 1992 (1992-10-26) * Absatz [0003] - Absatz [0030]; Abbildungen 1,2 * | 1-22 | |
| | ----- | | |
| A | EP 1 197 716 A1 (JAPAN SCIENCE & TECH CORP [JP]) 17. April 2002 (2002-04-17) * Absatz [0002] - Absatz [0041]; Abbildung 1 * | 1-22 | |
| | ----- | | |

**RECHERCHIERTE SACHGEBIETE (IPC)**

F25B
F17C

Der vorliegende Recherchenbericht wurde für alle Patentansprüche erstellt

| Recherchenort | Abschlußdatum der Recherche | Prüfer |
|---|---|---|
| München | 9. Mai 2025 | Lucic, Anita |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 21 9235

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-05-2025

| Im Recherchenbericht angeführtes Patentdokument | Datum der Veröffentlichung | Mitglied(er) der Patentfamilie | | Datum der Veröffentlichung |
|---|---|---|---|---|
| US 2022397311 A1 | 15-12-2022 | CN | 114556498 A | 27-05-2022 |
| | | EP | 4033176 A1 | 27-07-2022 |
| | | JP | 7139303 B2 | 20-09-2022 |
| | | JP | 2021071265 A | 06-05-2021 |
| | | US | 2022397311 A1 | 15-12-2022 |
| | | WO | 2021085157 A1 | 06-05-2021 |
| JP H04302404 A | 26-10-1992 | JP | 3043089 B2 | 22-05-2000 |
| | | JP | H04302404 A | 26-10-1992 |
| EP 1197716 A1 | 17-04-2002 | CA | 2355821 A1 | 06-07-2000 |
| | | DE | 69926087 T2 | 20-04-2006 |
| | | EP | 1197716 A1 | 17-04-2002 |
| | | EP | 1477755 A1 | 17-11-2004 |
| | | JP | 3446883 B2 | 16-09-2003 |
| | | JP | 2000193364 A | 14-07-2000 |
| | | US | 6442948 B1 | 03-09-2002 |
| | | WO | 0039513 A1 | 06-07-2000 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102022209941 A1
- US 20020002830 A1
- US 8671698 B
- US 20070107445 A1
- US 8375742 B2
- US 20090301129 A1
- EP 0245057 B1
- EP 0396624 B1
- DE 102021205423 A1
- DE 4039365 A1
- DE 102020204186 A1
- DE 69926087 T2

**In der Beschreibung aufgeführte Nicht-Patentliteratur**

- NMR Magnet System UltraShield Magnets (English Version) User Manual. Bruker BioSpin AG, 12 October 2004
- Helium is again short in supply. **D. KRAMER**. Physics Today. American Institute of Physics, 04 April 2022